# EUROPEAN PATENT SPECIFICATION

(11) **EP 4 471 830 B1**
(45) Date of publication and mention of the grant of the patent: **10.12.2025**
(21) Application number: 22921936.5
(22) Date of filing: 24.01.2022
(51) Int. Cl.: H10N 60/01, H10N 60/12, H10N 60/80

(54) **SUPERCONDUCTING CIRCUIT INCLUDING A JOSEPHSON ELEMENT, QUANTUM COMPUTATION DEVICE, AND METHOD FOR MANUFACTURING THE JOSEPHSON ELEMENT**
SUPRALEITENDE SCHALTUNG MIT EINEM JOSEPHSON-ELEMENT, QUANTENBERECHNUNGSVORRICHTUNG UND VERFAHREN ZUR HERSTELLUNG DES JOSEPHSON-ELEMENTS
CIRCUIT SUPRACONDUCTEUR COMPRENANT UN ÉLÉMENT JOSEPHSON, DISPOSITIF DE CALCUL QUANTIQUE ET PROCÉDÉ DE FABRICATION D'ÉLÉMENT JOSEPHSON

(43) Date of publication of application: 04.12.2024
(73) Proprietor: FUJITSU LIMITED, Kawasaki-shi, Kanagawa 211-8588 (JP)
(72) Inventor: TAKAHASHI, Tsuyoshi, Kawasaki-shi, Kanagawa 211-8588 (JP)
(74) Representative: Haseltine Lake Kempner LLP
(86) International application number: PCT/JP2022/002371
(87) International publication number: WO 2023/139779

(56) References cited:
- WO-A1-2019/117883
- CN-A- 113 921 691
- JP-A- 2020 535 461
- JP-A- H03 190 289
- JP-A- H04 346 277
- JP-A- H05 102 547
- JP-A- H05 102 547
- JP-A- H05 243 628
- US-A1- 2014 054 552
- US-A1- 2016 093 790
- US-A1- 2019 296 213

## Description

### TECHNICAL FIELD

The present disclosure relates to a Josephson device, a superconducting circuit, a quantum operation device, and a method for manufacturing a Josephson device.

### BACKGROUND ART

A quantum operation device includes a plurality of qubits, and the qubits include, for example, a Josephson device. The Josephson device includes two superconducting metal layers and an insulating layer therebetween. Conventionally, various configurations of the Josephson device have been proposed.

### CITATION LIST

### PATENT DOCUMENT

Patent Document 1: U.S. Patent Application Publication No. 2015/0340584
Patent Document 2: Japanese Laid-open Patent Publication No. 2-288403
Patent Document 3: U.S. Patent Application Publication No. 2004/0183065
Patent Document 4: Japanese Laid-open Patent Publication No. 5-315659
Patent Document 5: U.S. Patent Application Publication No. 2014/0054552 A1 relates to a microfabrication technique for Josephson junctions in superconducting integrated circuits, based on the use of a double-layer lithographic mask for partial anodization of the side-walls and base electrode of the junctions. The top layer of the mask is a resist material, and the bottom layer is a dielectric material chosen so to maximize adhesion between the resist and the underlying superconducting layer, be etch compatible with the underlying superconducting layer, and be insoluble in the resist and anodization processing chemistries.
Patent Document 6: Chinese Patent Application Publication 113921691 A relates to a Josephson junction, a Josephson junction array, and a preparation method and application. The preparation method of the Josephson junction comprises the steps of selecting an A-surface sapphire as a substrate, and preparing a quasi-epitaxial Ta superconducting film with a flat surface as a Josephson junction lower electrode based on a small lattice mismatch degree; furthermore, forming a compact, stable and controllable Ta2O5 oxide layer by an oxidation or deposition method to serve as a Josephson junction intermediate layer; depositing a Ta superconductive layer on the top electrode to serve as a Josephson junction top electrode; and then preparing a superconducting circuit and conducting a junction electrode by combining photoetching and an air bridge scheme so as to complete preparation of the Josephson junction array.
Patent Document 7: U.S. Patent Application Publication No. 2019/0296213 A1 relates to techniques for a vertical transmon qubit device. In one example, a chip surface base device structure is provided that comprises a first superconducting material physically coupled to a crystalline substrate, wherein the crystalline substrate is physically coupled to a second superconducting material, wherein the second superconducting material is physically coupled to a second crystalline substrate. In one implementation, the chip surface base device structure also comprises a vertical Josephson junction located in a via of the crystalline substrate, the vertical Josephson junction comprising the first superconducting material, a tunnel barrier, and the second superconducting material. In one implementation, the chip surface base device structure also comprises a transmon qubit comprising the vertical Josephson junction and a capacitor formed between the first superconducting material and the second superconducting material.
Patent Document 8: Japanese Laid-open Patent Publication No. 5-102547 relates to a resist film formed in a region having one Josephson junction in the same size and a region having three Josephson junctions of the same size and a portion in which a lower electrode is exposed is removed. A SiO2 film, which serves as an interlayer insulation film based on a bias sputtering method, is deposited. When the interlayer insulation film is formed based on the bias sputtering method, a process which deposits SiO2 and a process which etches SiO2 on an extruding portion are carried out in parallel, which forms an almost flattened SiO2 on the Josephson junctions. Then, a resist film is formed while an opening is formed. Through the opening, the SiO2 is etched, thereby forming a connection hole. A Nb layer is deposited on the whole. After wiring patterns are formed with the resist film, the Nb layer is etched so as to finish the process.

### SUMMARY OF INVENTION

### TECHNICAL PROBLEM

Characteristics may vary among the plurality of qubits included in the quantum operation device. When the characteristics vary among the plurality of qubits, a coherence time varies, and it becomes difficult to perform a stable quantum operation.

An object of the present invention is to provide a superconducting circuit including a Josephson device, a quantum operation device, and a method for manufacturing a Josephson device capable of suppressing variations in characteristics among a plurality of qubits.

### SOLUTION TO PROBLEM

According to an aspect of the present invention, there is provided a superconducting circuit including a Josephson device. The invention is defined in the independent claims.

### ADVANTAGEOUS EFFECTS OF INVENTION

According to the present invention, it is possible to suppress variations in characteristics among a plurality of qubits.

### BRIEF DESCRIPTION OF DRAWINGS

FIG. 1 is a plan view illustrating a vapor deposition mask used in a first reference example.
FIG. 2 is a cross-sectional view illustrating the vapor deposition mask used in the first reference example.
FIG. 3 is a cross-sectional view (part 1) illustrating a method for manufacturing a Josephson device according to the first reference example.
FIG. 4 is a cross-sectional view (part 2) illustrating the method for manufacturing the Josephson device according to the first reference example.
FIG. 5 is a schematic view (part 1) illustrating a relationship between a substrate and a vapor deposition source at the time of vapor deposition in the first reference example.
FIG. 6 is a schematic view (part 2) illustrating the relationship between the substrate and the vapor deposition source at the time of vapor deposition in the first reference example.
FIG. 7 is a cross-sectional view illustrating a difference in shape between two Josephson devices in the first reference example.
FIG. 8 is a plan view illustrating a vapor deposition mask used in a second reference example.
FIG. 9 is a cross-sectional view (part 1) illustrating the vapor deposition mask used in the second reference example.
FIG. 10 is a cross-sectional view (part 2) illustrating the vapor deposition mask used in the second reference example.
FIG. 11 is a cross-sectional view (part 1) illustrating a method for manufacturing a Josephson device according to the second reference example.
FIG. 12 is a cross-sectional view (part 2) illustrating the method for manufacturing the Josephson device according to the second reference example.
FIG. 13 is a cross-sectional view illustrating a difference in shape between two Josephson devices in the second reference example.
FIG. 14 is a plan view illustrating a Josephson device according to a first embodiment.
FIG. 15 is a cross-sectional view illustrating the Josephson device according to the first embodiment.
FIG. 16 is a cross-sectional view (part 1) illustrating a method for manufacturing the Josephson device according to the first embodiment.
FIG. 17 is a cross-sectional view (part 2) illustrating the method for manufacturing the Josephson device according to the first embodiment.
FIG. 18 is a cross-sectional view (part 3) illustrating the method for manufacturing the Josephson device according to the first embodiment.
FIG. 19 is a cross-sectional view (part 4) illustrating the method for manufacturing the Josephson device according to the first embodiment.
FIG. 20 is a cross-sectional view (part 5) illustrating the method for manufacturing the Josephson device according to the first embodiment.
FIG. 21 is a schematic view illustrating a relationship between a substrate and a vapor deposition source at the time of vapor deposition in the first embodiment.
FIG. 22 is a plan view illustrating a Josephson device according to a second embodiment.
FIG. 23 is a cross-sectional view illustrating the Josephson device according to the second embodiment.
FIG. 24 is a cross-sectional view (part 1) illustrating a method for manufacturing the Josephson device according to the second embodiment.
FIG. 25 is a cross-sectional view (part 2) illustrating the method for manufacturing the Josephson device according to the second embodiment.
FIG. 26 is a cross-sectional view (part 3) illustrating the method for manufacturing the Josephson device according to the second embodiment.
FIG. 27 is a cross-sectional view (part 4) illustrating the method for manufacturing the Josephson device according to the second embodiment.
FIG. 28 is a schematic view illustrating a relationship between a substrate and a vapor deposition source at the time of vapor deposition in the second embodiment.
FIG. 29 is a plan view illustrating a superconducting circuit according to a third embodiment.
FIG. 30 is a cross-sectional view illustrating the superconducting circuit according to the third embodiment.
FIG. 31 is a cross-sectional view (part 1) illustrating a method for manufacturing the superconducting circuit according to the third embodiment.
FIG. 32 is a cross-sectional view (part 2) illustrating the method for manufacturing the superconducting circuit according to the third embodiment.
FIG. 33 is a cross-sectional view (part 3) illustrating the method for manufacturing the superconducting circuit according to the third embodiment.
FIG. 34 is a cross-sectional view (part 4) illustrating the method for manufacturing the superconducting circuit according to the third embodiment.
FIG. 35 is a cross-sectional view (part 5) illustrating the method for manufacturing the superconducting circuit according to the third embodiment.
FIG. 36 is a cross-sectional view (part 6) illustrating the method for manufacturing the superconducting circuit according to the third embodiment.
FIG. 37 is a cross-sectional view (part 7) illustrating the method for manufacturing the superconducting circuit according to the third embodiment.
FIG. 38 is a cross-sectional view (part 8) illustrating the method for manufacturing the superconducting circuit according to the third embodiment.
FIG. 39 is a plan view illustrating a superconducting circuit according to a fourth embodiment.
FIG. 40 is a cross-sectional view illustrating the superconducting circuit according to the fourth embodiment.
FIG. 41 is a cross-sectional view (part 1) illustrating a method for manufacturing the superconducting circuit according to the fourth embodiment.
FIG. 42 is a cross-sectional view (part 2) illustrating the method for manufacturing the superconducting circuit according to the fourth embodiment.
FIG. 43 is a cross-sectional view (part 3) illustrating the method for manufacturing the superconducting circuit according to the fourth embodiment.
FIG. 44 is a cross-sectional view illustrating a superconducting circuit according to a fifth embodiment.
FIG. 45 is a cross-sectional view (part 1) illustrating a method for manufacturing the superconducting circuit according to the fifth embodiment.
FIG. 46 is a cross-sectional view (part 2) illustrating the method for manufacturing the superconducting circuit according to the fifth embodiment.
FIG. 47 is a cross-sectional view (part 3) illustrating the method for manufacturing the superconducting circuit according to the fifth embodiment.
FIG. 48 is a cross-sectional view (part 4) illustrating the method for manufacturing the superconducting circuit according to the fifth embodiment.
FIG. 49 is a plan view illustrating a superconducting circuit according to a sixth embodiment.
FIG. 50 is a cross-sectional view illustrating the superconducting circuit according to the sixth embodiment.
FIG. 51 is a cross-sectional view (part 1) illustrating a method for manufacturing the superconducting circuit according to the sixth embodiment.
FIG. 52 is a cross-sectional view (part 2) illustrating the method for manufacturing the superconducting circuit according to the sixth embodiment.
FIG. 53 is a cross-sectional view (part 3) illustrating the method for manufacturing the superconducting circuit according to the sixth embodiment.
FIG. 54 is a cross-sectional view illustrating a superconducting circuit according to a seventh embodiment.
FIG. 55 is a cross-sectional view (part 1) illustrating a method for manufacturing the superconducting circuit according to the seventh embodiment.
FIG. 56 is a cross-sectional view (part 2) illustrating the method for manufacturing the superconducting circuit according to the seventh embodiment.
FIG. 57 is a cross-sectional view (part 3) illustrating the method for manufacturing the superconducting circuit according to the seventh embodiment.
FIG. 58 is a cross-sectional view illustrating a superconducting circuit according to a modification of the fifth embodiment.
FIG. 59 is a diagram illustrating a quantum operation device according to an eighth embodiment.

### DESCRIPTION OF EMBODIMENTS

Hereinafter, embodiments of the present disclosure will be specifically described with reference to the accompanying drawings. Note that, in the present specification and the drawings, components having substantially the same functional configurations are denoted by the same reference signs, and redundant description may be omitted. In the present disclosure, a plan view means a plan view from a direction perpendicular to an upper surface of a substrate.

First, reference examples of a method for manufacturing a Josephson device will be described. In the reference examples, a superconducting metal layer is formed on a substrate using a vapor deposition mask.

### (First Reference Example)

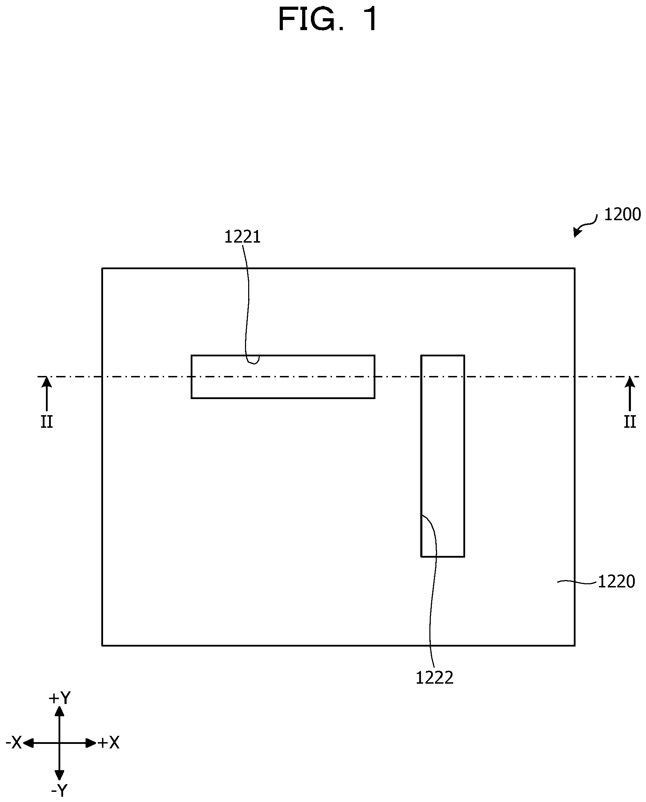

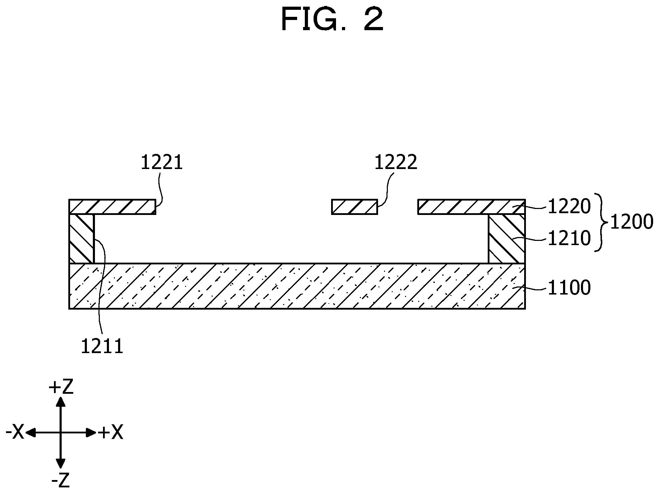

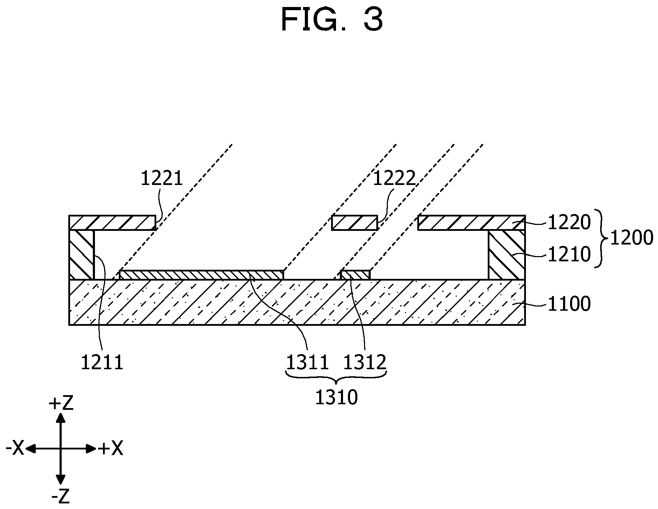

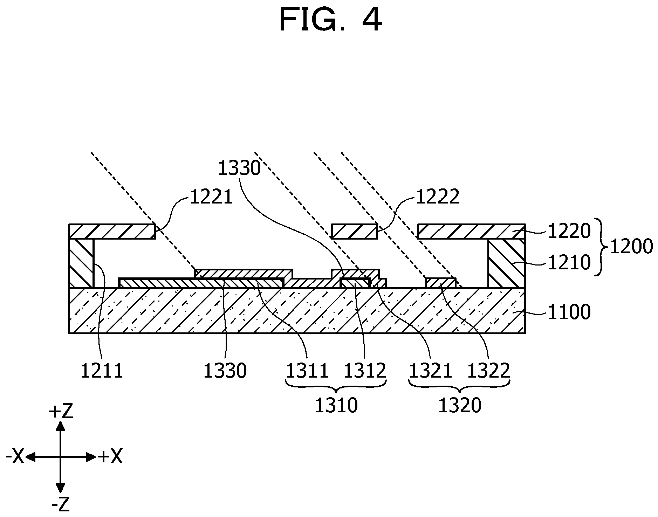

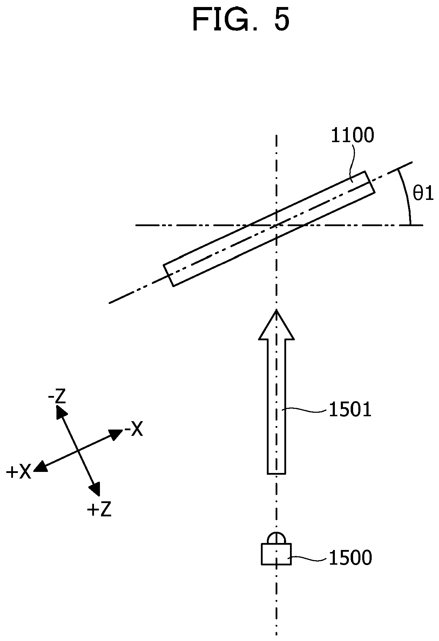

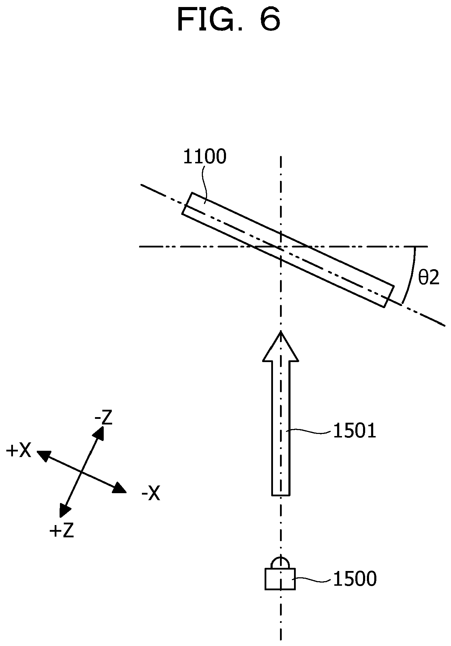

A first reference example will be described. FIG. 1 is a plan view illustrating a vapor deposition mask used in the first reference example. FIG. 2 is a cross-sectional view illustrating the vapor deposition mask used in the first reference example. FIG. 2 corresponds to a cross-sectional view taken along a line II-II in FIG. 1. FIGs. 3 and 4 are cross-sectional views illustrating a method for manufacturing a Josephson device according to the first reference example. FIGs. 5 and 6 are schematic views illustrating a relationship between a substrate and a vapor deposition source at the time of vapor deposition in the first reference example.

A vapor deposition mask 1200 used in the first reference example includes a first resist layer 1210 and a second resist layer 1220. The first resist layer 1210 is provided on a substrate 1100, and the second resist layer 1220 is provided on the first resist layer 1210. The second resist layer 1220 includes a first opening pattern 1221 extending in an X-axis direction parallel to an upper surface of the substrate 1100 and a second opening pattern 1222 extending in a Y-axis direction parallel to the upper surface of the substrate 1100 and perpendicular to the X-axis direction. The second opening pattern 1222 is positioned in the vicinity of one end of the first opening pattern 1221. The first resist layer 1210 includes an opening pattern 1211 surrounding the first opening pattern 1221 and the second opening pattern 1222 at least in a plan view from a Z-axis direction perpendicular to the upper surface of the substrate 1100.

When a Josephson device is manufactured, first, as illustrated in FIG. 3, a first superconducting metal layer 1310 is formed on the substrate 1100 by a vapor deposition method. At this time, as illustrated in FIG. 5, the Z-axis direction of the substrate 1100 is not parallel to a traveling direction 1501 of an evaporation substance emitted from a vapor deposition source 1500. Specifically, a direction inclined from a +Z side to a +X side of the substrate 1100 is a direction parallel to the traveling direction 1501. An inclination angle θ1 at this time is such an extent that the evaporation substance passes through both the first opening pattern 1221 and the second opening pattern 1222. The first superconducting metal layer 1310 is formed at a position shifted to a -X side from the first opening pattern 1221 and the second opening pattern 1222 in a plan view from the Z-axis direction. The first superconducting metal layer 1310 includes a first pattern 1311 including an evaporation raw material that has passed through the first opening pattern 1221, and a second pattern 1312 including an evaporation raw material that has passed through the second opening pattern 1222. The first pattern 1311 extends in the X-axis direction similarly to the first opening pattern 1221, and the second pattern 1312 extends in the Y-axis direction similarly to the second opening pattern 1222.

After the formation of the first superconducting metal layer 1310, as illustrated in FIG. 4, a surface of the first superconducting metal layer 1310 is oxidized to form an oxide film 1330. Next, as similarly illustrated in FIG. 4, a second superconducting metal layer 1320 is formed on the substrate 1100 and the oxide film 1330 by the vapor deposition method. At this time, as illustrated in FIG. 6, the Z-axis direction of the substrate 1100 is not parallel to the traveling direction 1501 of the evaporation substance emitted from the vapor deposition source 1500. Specifically, a direction inclined from the +Z side to the -X side of the substrate 1100 is a direction parallel to the traveling direction 1501. An inclination angle θ2 at this time is such an extent that the evaporation substance passes through both the first opening pattern 1221 and the second opening pattern 1222. The second superconducting metal layer 1320 is formed at a position shifted to the +X side from the first opening pattern 1221 and the second opening pattern 1222 in a plan view from the Z-axis direction. The second superconducting metal layer 1320 includes a first pattern 1321 including an evaporation raw material that has passed through the first opening pattern 1221, and a second pattern 1322 including an evaporation raw material that has passed through the second opening pattern 1222. The first pattern 1321 extends in the X-axis direction similarly to the first opening pattern 1221, and the second pattern 1322 extends in the Y-axis direction similarly to the second opening pattern 1222.

The second pattern 1312 of the first superconducting metal layer 1310 and the first pattern 1321 of the second superconducting metal layer 1320 are stacked with the oxide film 1330 interposed therebetween. The second pattern 1312 of the first superconducting metal layer 1310, the oxide film 1330, and the first pattern 1321 of the second superconducting metal layer 1320 constitute a Josephson device.

However, an incident angle of the evaporation substance to the substrate 1100 when the first superconducting metal layer 1310 is formed varies depending on a position in the X-axis direction. For example, when the first superconducting metal layer 1310 is formed, an incident angle to a center of the substrate 1100 is 90° - 81, but an incident angle to the vicinity of an end on the +X side of the substrate 1100 is greater than 90° - θ1 and the incident angle to the vicinity of the end on the +X side of the substrate 1100 is smaller than 90° - θ1. For example, when it is assumed that a diameter of the substrate 1100 is 6 inches (about 15 cm), a distance between the center of the substrate 1100 and the vapor deposition source 1500 is 60 cm, and the inclination angle θ1 is 30°, the incident angle to the center of the substrate 1100 is 60°, the incident angle to the end on the +X side of the substrate 1100 is 66.3°, and the incident angle to the vicinity of the end on the +X side of the substrate 1100 is 54.2°. Therefore, a difference of up to 12.1° occurs in the incident angle.

Similarly, an incident angle of the evaporation substance to the substrate 1100 when the second superconducting metal layer 1320 is formed also varies depending on the position in the X-axis direction. For example, when the second superconducting metal layer 1320 is formed, an incident angle to the center of the substrate 1100 is 90° - θ2, but an incident angle to the vicinity of the end on the +X side of the substrate 1100 is smaller than 90° - θ2 and the incident angle to the vicinity of the end on the +X side of the substrate 1100 is greater than 90° - θ2.

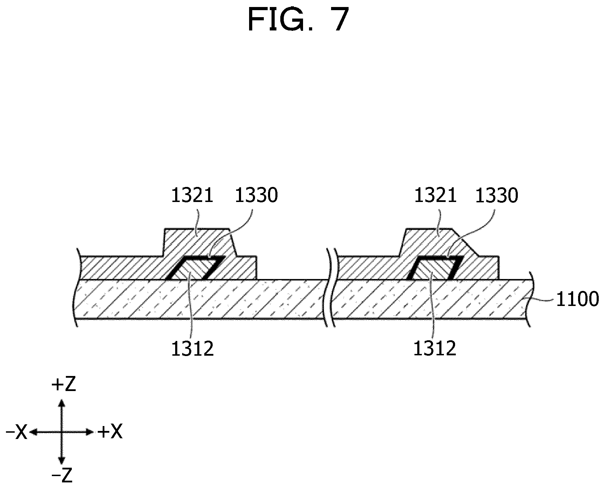

Therefore, strictly speaking, as illustrated in FIG. 7, a Josephson device formed in the vicinity of the end on the +X side of the substrate 1100 and a Josephson device formed in the vicinity of an end on the -X side have different shapes. In the first reference example, this difference in shape causes variations in characteristics of Josephson devices. Furthermore, disconnection may occur in the second superconducting metal layer 1320. FIG. 7 is a cross-sectional view illustrating the difference in shape between the two Josephson devices in the first reference example.

### (Second Reference Example)

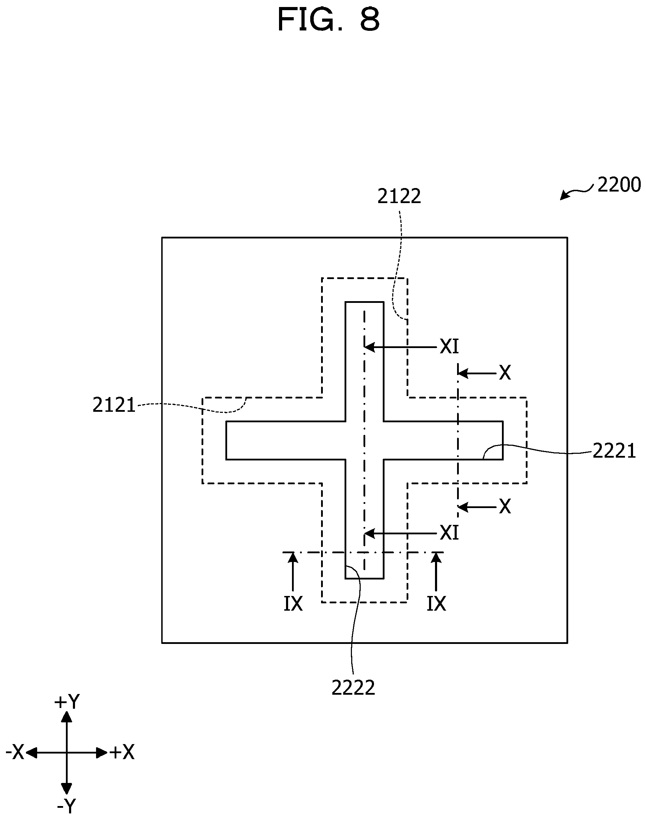

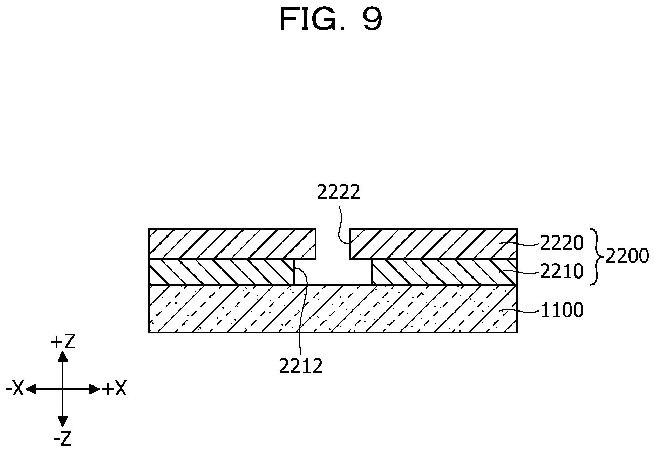

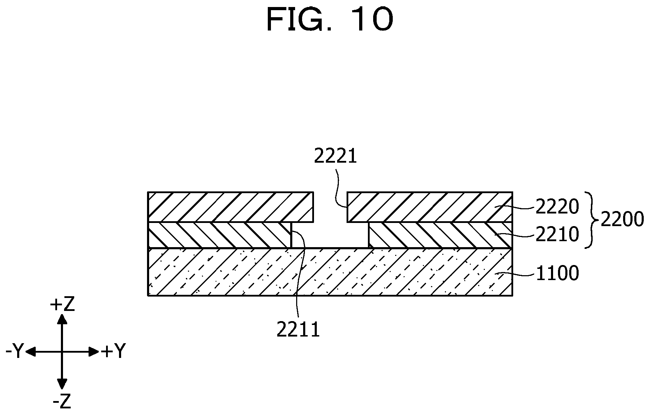

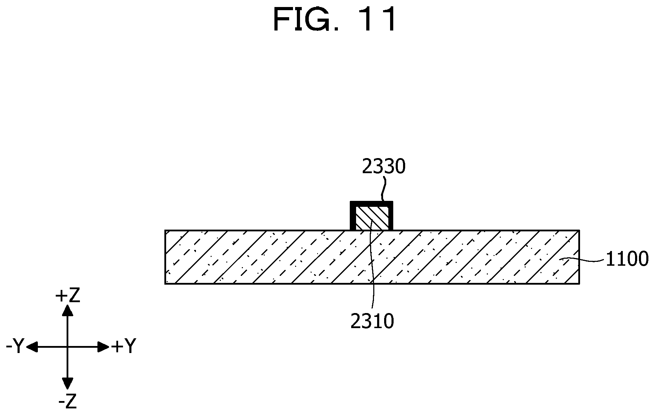

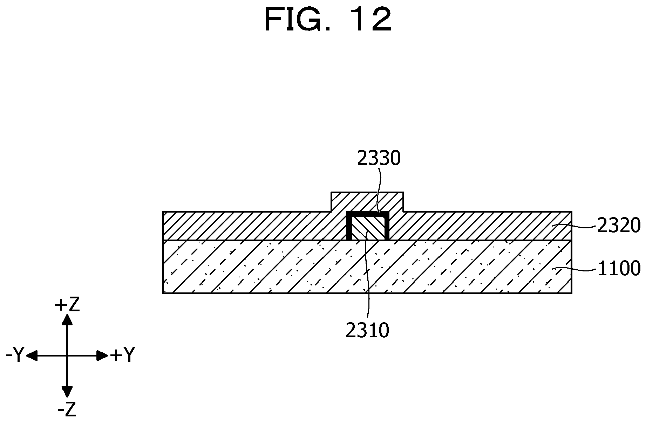

A second reference example will be described. FIG. 8 is a plan view illustrating a vapor deposition mask used in the second reference example. FIGs. 9 and 10 are cross-sectional views illustrating the vapor deposition mask used in the second reference example. FIG. 9 corresponds to a cross-sectional view taken along a line IX-IX in FIG. 8, and FIG. 10 corresponds to a cross-sectional view taken along a line X-X in FIG. 8. FIGs. 11 and 12 are cross-sectional views illustrating a method for manufacturing a Josephson device according to the second reference example. FIGs. 11 and 12 correspond to cross-sectional views taken along a line XI-XI in FIG. 8.

A vapor deposition mask 2200 used in the second reference example includes a first resist layer 2210 and a second resist layer 2220. The first resist layer 2210 is provided on a substrate 1100, and the second resist layer 2220 is provided on the first resist layer 2210. The second resist layer 2220 includes a first opening pattern 2221 extending in the X-axis direction parallel to an upper surface of the substrate 1100 and a second opening pattern 2222 extending in the Y-axis direction parallel to the upper surface of the substrate 1100 and perpendicular to the X-axis direction. The first opening pattern 2221 and the second opening pattern 2222 intersect each other in the vicinity of a center in a longitudinal direction. The first resist layer 2210 includes a first opening pattern 2211 surrounding the first opening pattern 2221 and a second opening pattern 2212 surrounding the second opening pattern 2222 in a plan view from the Z-axis direction perpendicular to the upper surface of the substrate 1100.

When a Josephson device is manufactured, first, as illustrated in FIG. 11, a first superconducting metal layer 2310 is formed on the substrate 1100 by the vapor deposition method. At this time, similarly to the first reference example, the Z-axis direction of the substrate 1100 is not parallel to a traveling direction 1501 of an evaporation substance emitted from a vapor deposition source 1500. Specifically, a direction inclined from the +Z side to the +X side of the substrate 1100 is a direction parallel to the traveling direction 1501. An inclination angle at this time is such an extent that the evaporation substance passes through the first opening pattern 2221 but may not pass through the second opening pattern 2222. The first superconducting metal layer 2310 extends in the X-axis direction similarly to the first opening pattern 2221.

After the formation of the first superconducting metal layer 2310, as illustrated in FIG. 12, a surface of the first superconducting metal layer 2310 is oxidized to form an oxide film 2330. Next, as similarly illustrated in FIG. 12, a second superconducting metal layer 2320 is formed on the substrate 1100 and the oxide film 2330 by the vapor deposition method. At this time, the Z-axis direction of the substrate 1100 is not parallel to the traveling direction 1501 of the evaporation substance emitted from the vapor deposition source 1500. Specifically, a direction inclined from the +Z side to a +Y side of the substrate 1100 is a direction parallel to the traveling direction 1501. An inclination angle at this time is such an extent that the evaporation substance passes through the second opening pattern 2222 but may not pass through the first opening pattern 2221. The second superconducting metal layer 2320 extends in the Y-axis direction similarly to the second opening pattern 2222. That is, the first superconducting metal layer 2310 and the second superconducting metal layer 2320 intersect.

The first superconducting metal layer 2310 and the second superconducting metal layer 2320 are stacked with the oxide film 2330 interposed therebetween. The first superconducting metal layer 2310, the oxide film 2330, and the second superconducting metal layer 2320 constitute a Josephson device.

However, an incident angle of the evaporation substance to the substrate 1100 when the first superconducting metal layer 2310 is formed varies depending on a position in the X-axis direction, and an incident angle of the evaporation substance to the substrate 1100 when the second superconducting metal layer 2320 is formed varies depending on a position in the Y-axis direction.

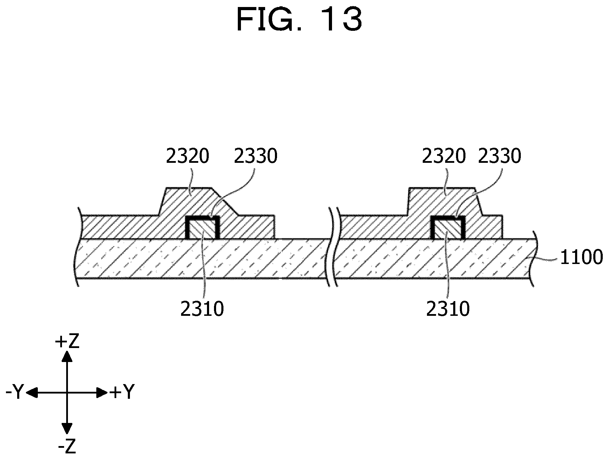

Therefore, strictly speaking, as illustrated in FIG. 13, a Josephson device formed in the vicinity of an end on the +Y side of the substrate 1100 and a Josephson device formed in the vicinity of an end on a -Y side have different shapes. In the second reference example, this difference in shape causes variations in characteristics of Josephson devices. Furthermore, disconnection may occur in the second superconducting metal layer 2320. FIG. 13 is a cross-sectional view illustrating the difference in shape between the two Josephson devices in the second reference example.

Based on the findings described above, the inventor of the present application conducted intensive studies to suppress variations in characteristics among a plurality of qubits, and conceived the following embodiments.

### (First Embodiment)

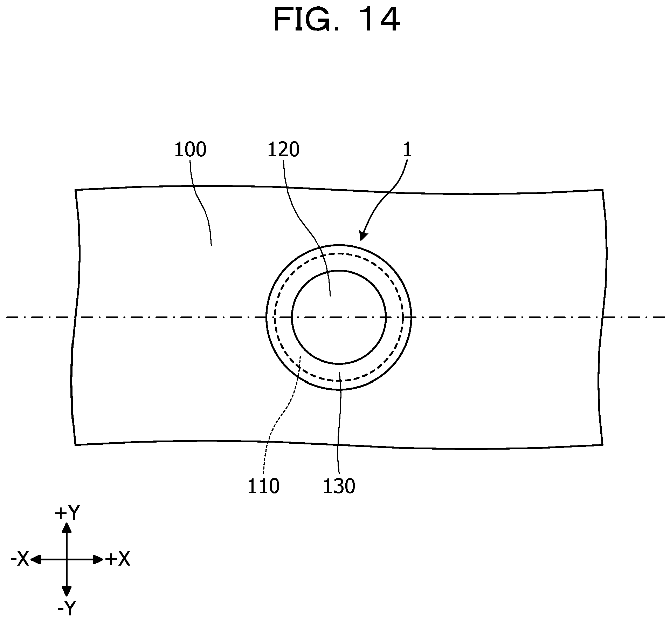

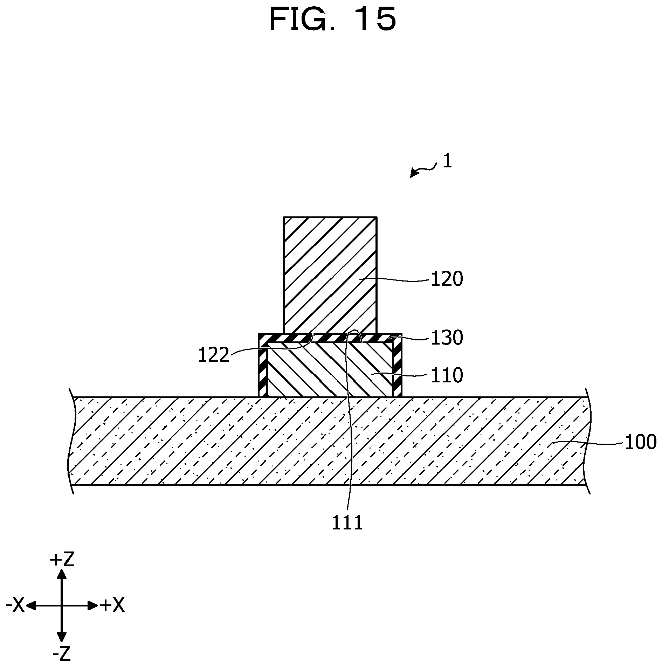

A first embodiment will be described. FIG. 14 is a plan view illustrating a Josephson device according to the first embodiment. FIG. 15 is a cross-sectional view illustrating the Josephson device according to the first embodiment. FIG. 15 corresponds to a cross-sectional view taken along a dash-dot line in FIG. 14.

A Josephson device 1 according to the first embodiment includes a first superconducting metal layer 110, a second superconducting metal layer 120, and an insulating layer 130. The first superconducting metal layer 110 includes an upper surface 111, and the second superconducting metal layer 120 includes a lower surface 122. The lower surface 122 faces the upper surface 111. Each of the first superconducting metal layer 110 and the second superconducting metal layer 120 has a substantially cylindrical shape. The insulating layer 130 is provided between the upper surface 111 of the first superconducting metal layer 110 and the lower surface 122 of the second superconducting metal layer 120. In a plan view from a direction perpendicular to the upper surface 111, an outline of the lower surface 122 is inside an outline of the upper surface 111. The insulating layer 130 may also be provided on a side surface of the first superconducting metal layer 110. The Josephson device 1 is provided on, for example, a substrate 100. The upper surface 111 is an example of a first surface, and the lower surface 122 is an example of a second surface.

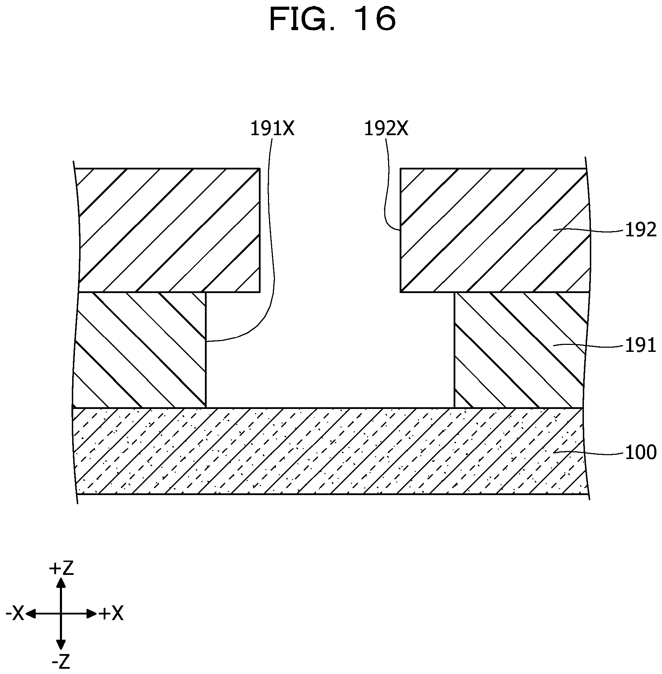

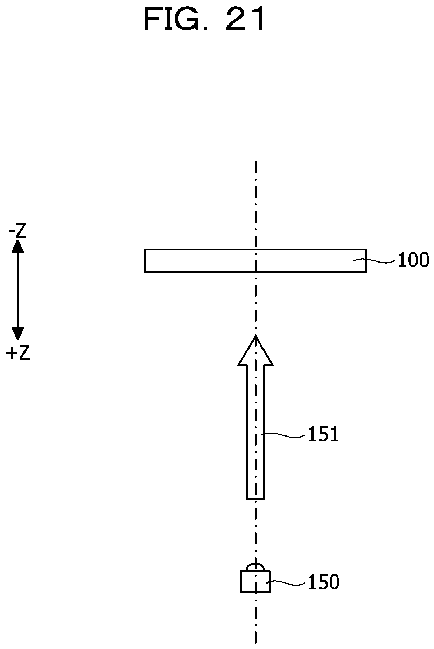

Next, a method for manufacturing the Josephson device 1 will be described. FIGs. 16 to 20 are cross-sectional views illustrating the method for manufacturing the Josephson device 1 according to the first embodiment of the invention according to claim 11. FIG. 21 is a schematic view illustrating a relationship between the substrate and a vapor deposition source at the time of vapor deposition in the first embodiment.

First, as illustrated in FIG. 16, a resist layer 191 including an opening 191X and a resist layer 192 including an opening 192X are formed on the substrate 100. The resist layer 191 is formed on a side of the substrate 100 of the resist layer 192. The opening 192X has a shape and a size corresponding to the upper surface of the first superconducting metal layer 110 to be formed in a plan view. The opening 191X surrounds the opening 192X in a plan view.

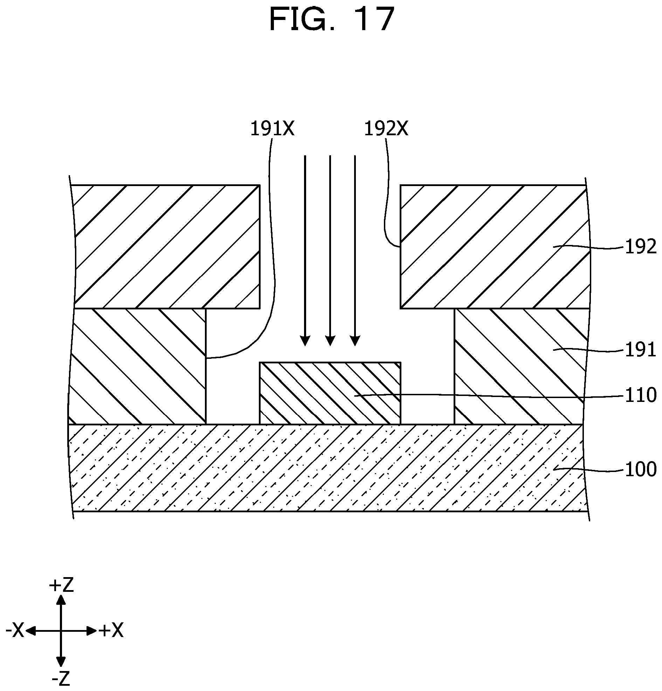

Next, as illustrated in FIG. 17, the first superconducting metal layer 110 is formed on the substrate 100 inside the opening 191X by the vapor deposition method using the resist layers 191 and 192 as vapor deposition masks. At this time, as illustrated in FIG. 21, the Z-axis direction of the substrate 100 is parallel to a traveling direction 151 of an evaporation substance (first evaporation substance) emitted from a vapor deposition source 150. Therefore, an incident angle of the evaporation substance to a center of the substrate 100 is 90°.

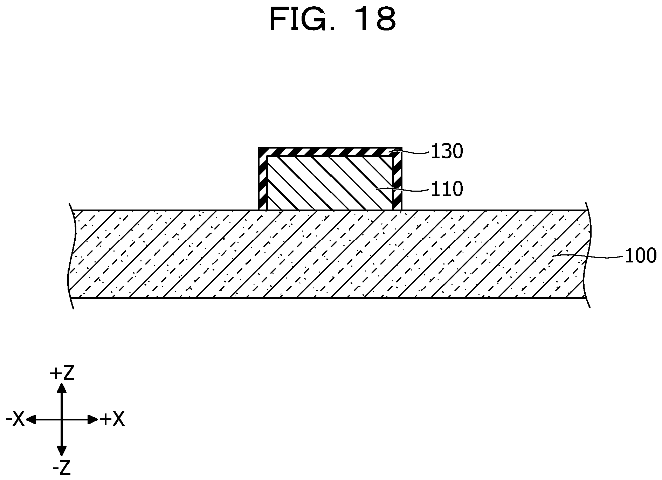

Thereafter, as illustrated in FIG. 18, the resist layers 191 and 192 are removed. Although not illustrated, the evaporation substance is deposited also on the resist layer 192, but the deposited evaporation substance is removed together with the resist layers 191 and 192. That is, lift-off is performed. Furthermore, the surface (the upper surface and the side surface) of the first superconducting metal layer 110 is oxidized to form the insulating layer 130.

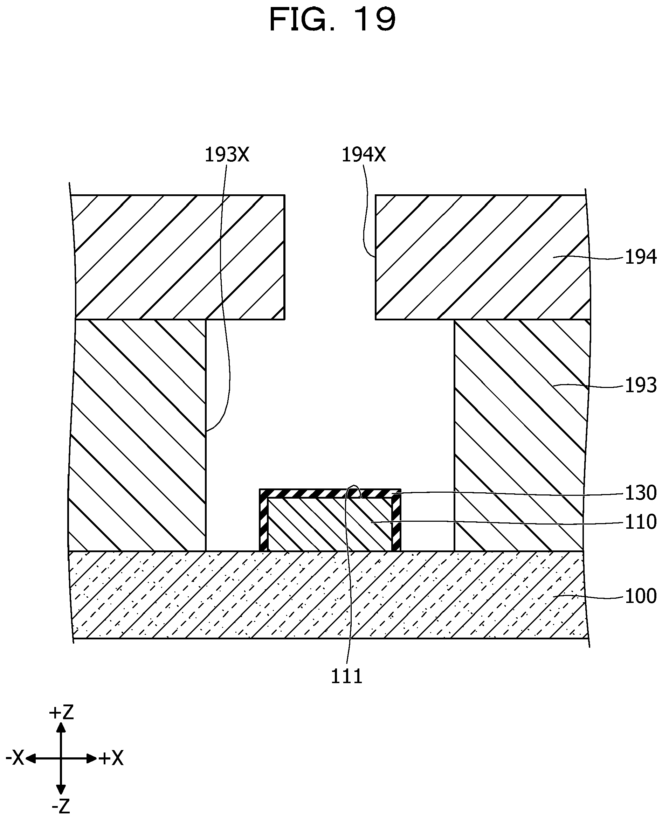

Subsequently, as illustrated in FIG. 19, a resist layer 193 including an opening 193X and a resist layer 194 including an opening 194X are formed on the substrate 100. The resist layer 193 is formed on a side of the substrate 100 of the resist layer 194. The opening 194X surrounds the outline of the upper surface 111 of the first superconducting metal layer 110 in a plan view, and has a shape and a size corresponding to an upper surface of the second superconducting metal layer 120 to be formed. The opening 193X surrounds the opening 194X in a plan view.

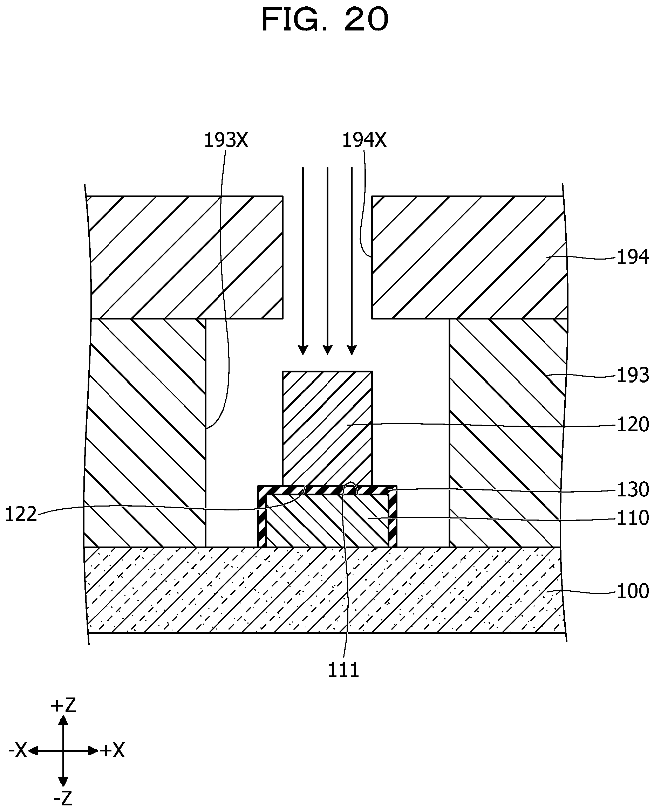

Next, as illustrated in FIG. 20, the second superconducting metal layer 120 is formed on a portion of the insulating layer 130 on the upper surface 111 of the first superconducting metal layer 110 inside the opening 193X by the vapor deposition method using the resist layers 193 and 194 as vapor deposition masks. Also at this time, as illustrated in FIG. 21, the Z-axis direction of the substrate 100 is parallel to the traveling direction 151 of the evaporation substance (second evaporation substance). Therefore, an incident angle of the evaporation substance to the center of the substrate 100 is 90°.

Thereafter, the resist layers 193 and 194 are removed (see FIG. 15). Although not illustrated, the evaporation substance is deposited also on the resist layer 194, but the deposited evaporation substance is removed together with the resist layers 193 and 194. That is, lift-off is performed.

In this manner, the Josephson device 1 according to the first embodiment may be manufactured.

In the present embodiment, the outline of the lower surface 122 of the second superconducting metal layer 120 is inside the outline of the upper surface 111 of the first superconducting metal layer 110 in a plan view. Therefore, the Z-axis direction of the substrate 100 may be made parallel to the traveling direction 151 of the evaporation substance at the time of the formation of the first superconducting metal layer 110 and at the time of the formation of the second superconducting metal layer 120. Therefore, it is possible to suppress a difference in incident angle of the evaporation substance to the substrate 100. For example, when it is assumed that a diameter of the substrate 100 is 6 inches (about 15 cm) and a distance between the center of the substrate 100 and the vapor deposition source 150 is 60 cm, an incident angle to the center of the substrate 100 is 90° and an incident angle to an end of the substrate 100 is 82.9°. Therefore, the difference in incident angle is at most 7.1°.

Therefore, a difference in shape among a plurality of the Josephson devices 1 formed on the substrate 100 is slight, and it is possible to suppress variations in characteristics of the Josephson devices 1.

### (Second Embodiment)

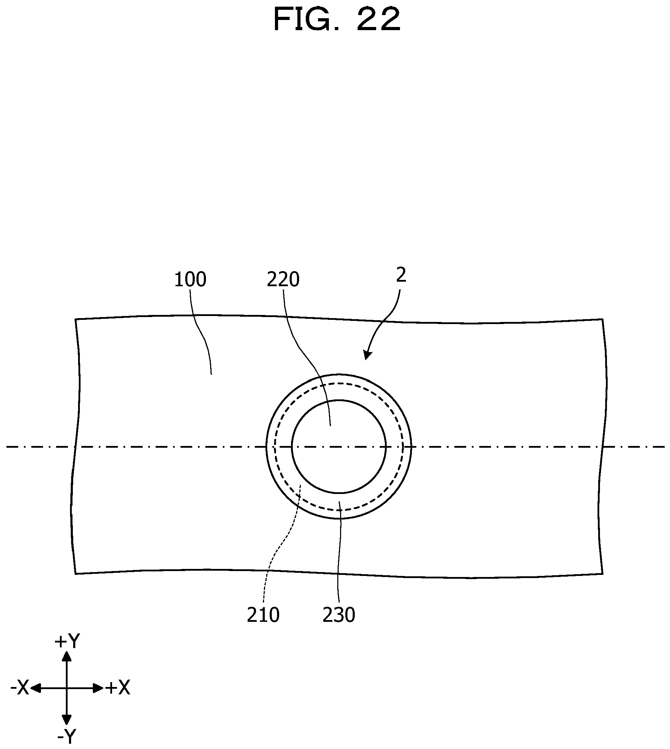

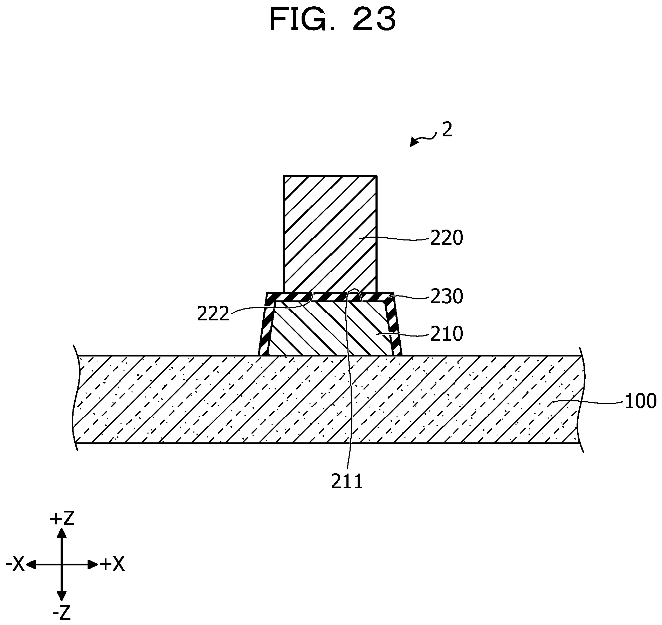

A second embodiment will be described. FIG. 22 is a plan view illustrating a Josephson device according to a second embodiment. FIG. 23 is a cross-sectional view illustrating the Josephson device according to the second embodiment. FIG. 23 corresponds to a cross-sectional view taken along a dash-dot line XXIII-XXIII.

A Josephson device 2 according to the second embodiment includes a first superconducting metal layer 210, a second superconducting metal layer 220, and an insulating layer 230. The first superconducting metal layer 210 includes an upper surface 211, and the second superconducting metal layer 220 includes a lower surface 222. The lower surface 222 faces the upper surface 211. The first superconducting metal layer 210 has a substantially truncated cone shape, and the second superconducting metal layer 220 has a substantially cylindrical shape. The insulating layer 230 is provided between the upper surface 211 of the first superconducting metal layer 210 and the lower surface 222 of the second superconducting metal layer 220. In a plan view from a direction perpendicular to the upper surface 211, an outline of the lower surface 222 is inside an outline of the upper surface 211. The insulating layer 230 may also be provided on a side surface of the first superconducting metal layer 210. The Josephson device 2 is provided on, for example, a substrate 100. The upper surface 211 is an example of the first surface, and the lower surface 222 is an example of the second surface.

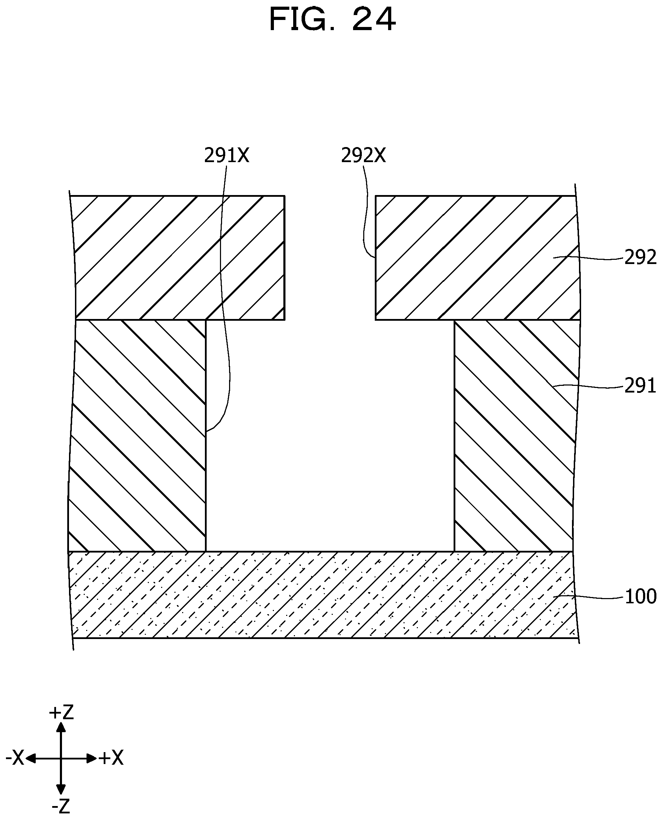

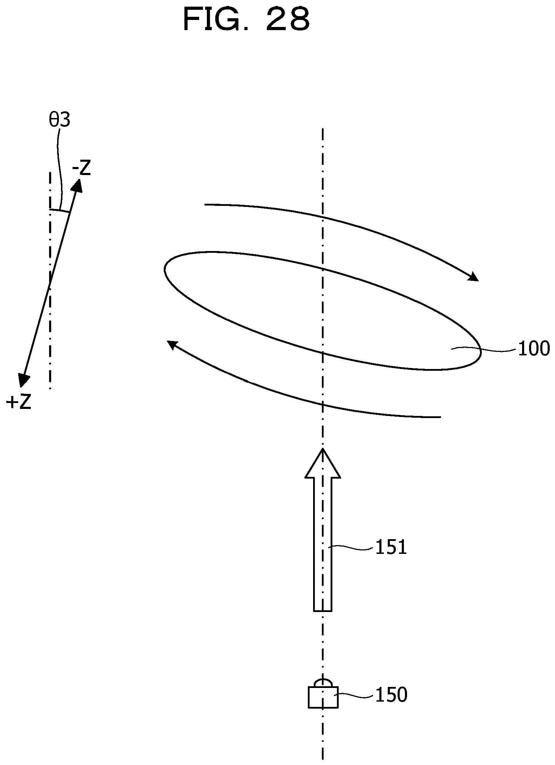

Next, a method for manufacturing the Josephson device 2 will be described. FIGs. 24 to 27 are cross-sectional views illustrating the method for manufacturing the Josephson device 2 according to the second embodiment. FIG. 28 is a schematic view illustrating a relationship between the substrate and a vapor deposition source at the time of vapor deposition in the second embodiment.

First, as illustrated in FIG. 24, a resist layer 291 including an opening 291X and a resist layer 292 including an opening 292X are formed on the substrate 100. The resist layer 291 is formed on a side of the substrate 100 of the resist layer 292. The opening 292X has a shape and a size corresponding to an upper surface of the second superconducting metal layer 220 to be formed in a plan view. The opening 291X has a shape and a size surrounding an outline of a lower surface of the first superconducting metal layer 210 to be formed in a plan view.

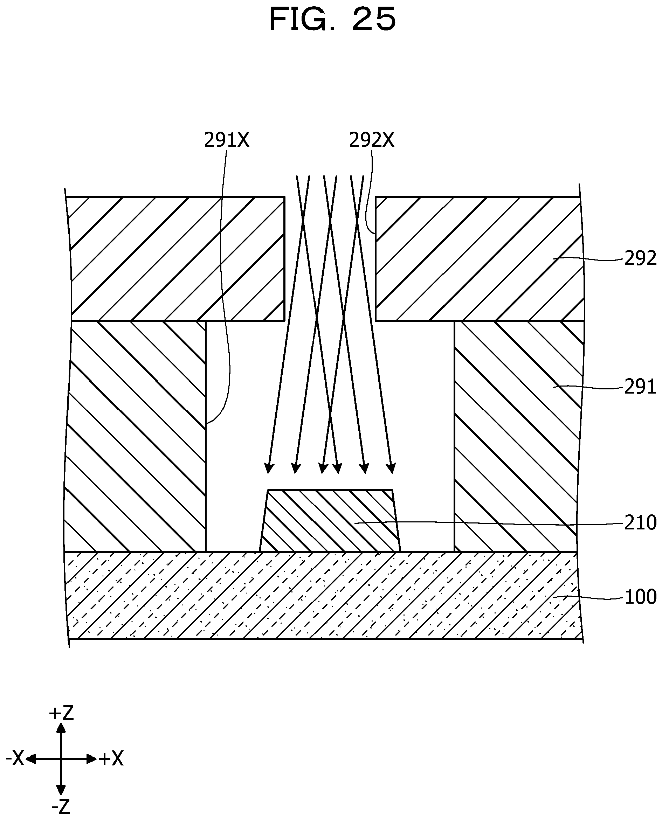

Next, as illustrated in FIG. 25, the first superconducting metal layer 210 is formed on the substrate 100 inside the opening 291X by the vapor deposition method using the resist layers 291 and 292 as vapor deposition masks. At this time, as illustrated in FIG. 28, the Z-axis direction of the substrate 100 is not parallel to a traveling direction 151 of an evaporation substance (first evaporation substance) emitted from a vapor deposition source 150, and the substrate 100 is rotated around a straight line passing through a center of an upper surface of the substrate 100 and perpendicular to the upper surface as a rotation center. An inclination angle θ3 at this time is such an extent that a portion where the lower surface 222 of the second superconducting metal layer 220 to be formed later is positioned may be seen from the vapor deposition source 150 at any position in the substrate 100. The inclination angle θ3 is, for example, about 1° to 10°.

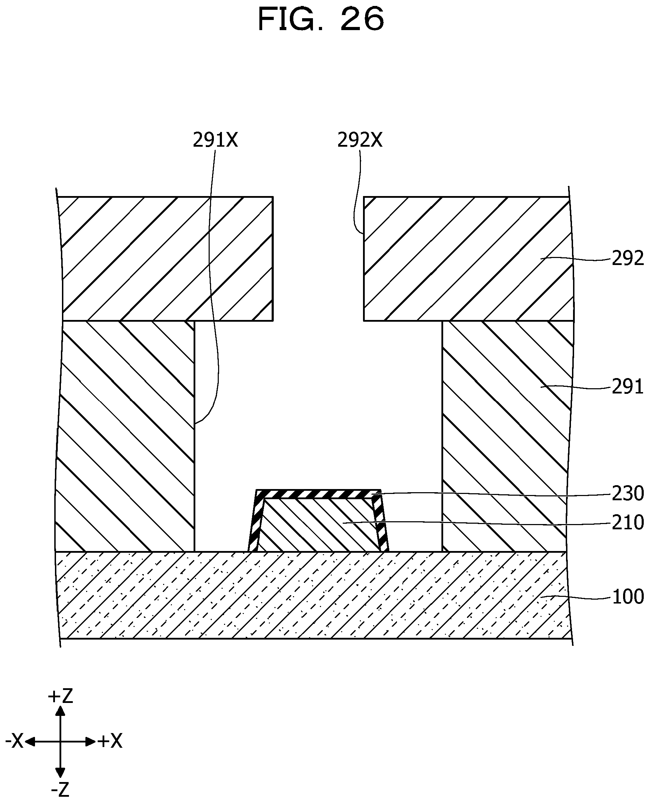

Thereafter, as illustrated in FIG. 26, the surface (the upper surface and side surfaces) of the first superconducting metal layer 210 is oxidized to form the insulating layer 230 while leaving the resist layers 291 and 292.

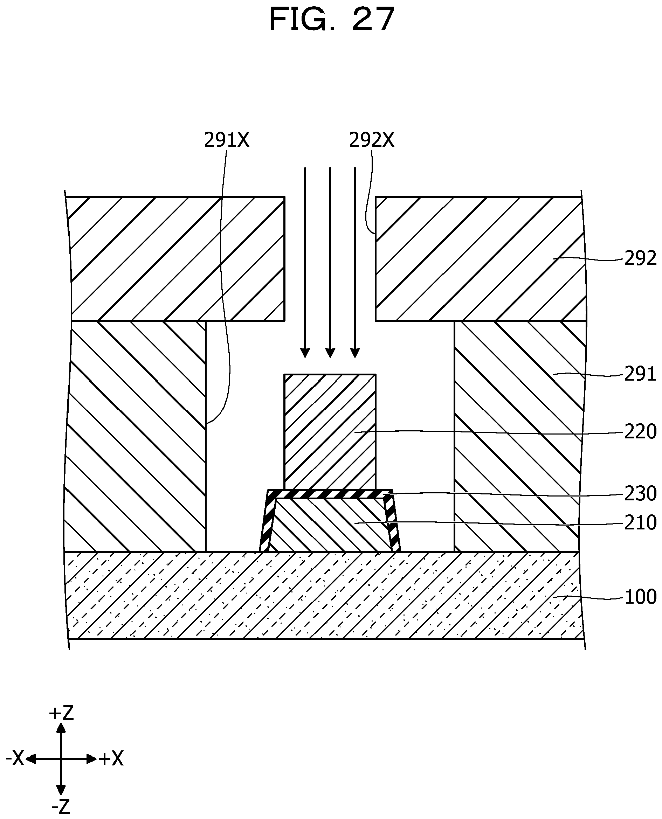

Subsequently, as illustrated in FIG. 27, the second superconducting metal layer 220 is formed on a portion of the insulating layer 230 on the upper surface 211 of the first superconducting metal layer 210 inside the opening 291X by the vapor deposition method using the resist layers 291 and 292 as vapor deposition masks. At this time, as illustrated in FIG. 21, the Z-axis direction of the substrate 100 is parallel to the traveling direction 151 of the evaporation substance (second evaporation substance). Therefore, an incident angle of the evaporation substance to the center of the substrate 100 is 90°.

Preferably, the formation of the first superconducting metal layer 210, the formation of the insulating layer 230, and the formation of the second superconducting metal layer 220 are continuously performed while maintaining a vacuum state in a vacuum chamber.

Thereafter, the resist layers 291 and 292 are removed (see FIG. 23). Although not illustrated, at the time of the formation of the first superconducting metal layer 210 and at the time of the formation of the second superconducting metal layer 220, the evaporation substance is deposited also on the resist layer 292, but the deposited evaporation substance is removed together with the resist layers 291 and 292. That is, lift-off is performed.

In this manner, the Josephson device 2 according to the second embodiment may be manufactured.

In the present embodiment, the outline of the lower surface 222 of the second superconducting metal layer 220 is inside the outline of the upper surface 211 of the first superconducting metal layer 210 in a plan view. Therefore, the inclination angle θ3 at the time of the formation of the first superconducting metal layer 210 may be reduced, and the Z-axis direction of the substrate 100 may be made parallel to the traveling direction 151 of the evaporation substance at the time of the formation of the second superconducting metal layer 220. Therefore, similarly to the first embodiment, it is possible to suppress a difference in incident angle of the evaporation substance to the substrate 100.

Therefore, a difference in shape among a plurality of the Josephson devices 2 formed on the substrate 100 is slight, and it is possible to suppress variations in characteristics of the Josephson devices 2.

Moreover, since the first superconducting metal layer 210 and the second superconducting metal layer 220 may be formed using the resist layers 191 and 192, a throughput may be improved.

### (Third Embodiment)

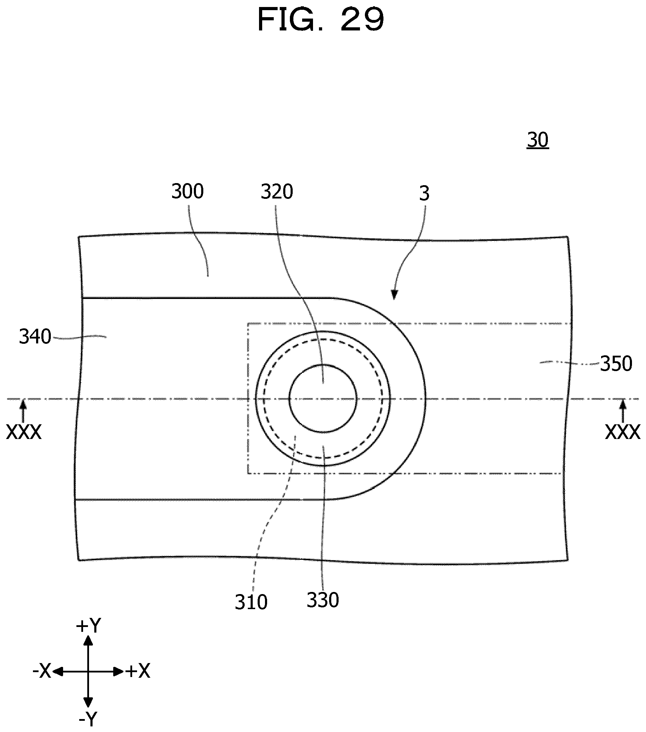

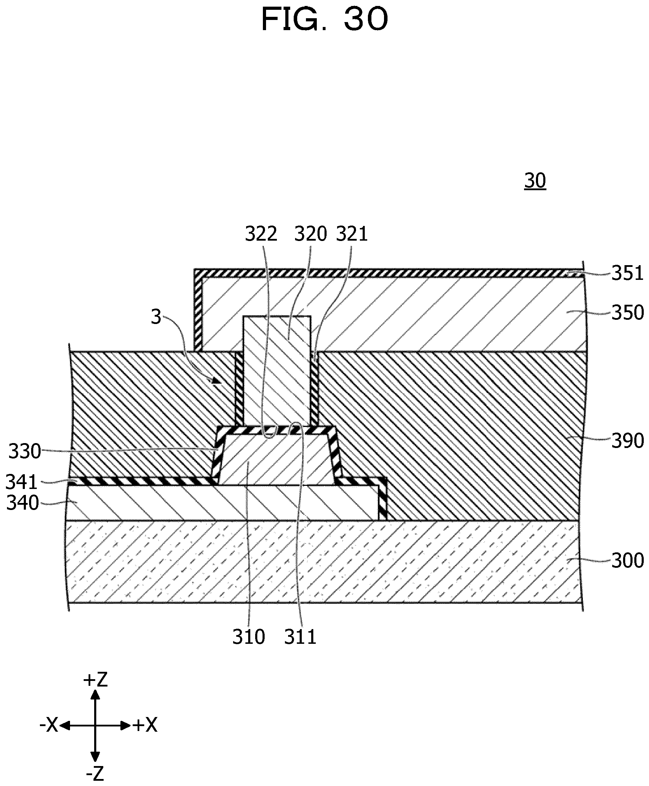

A third embodiment will be described. A third embodiment relates to a superconducting circuit including a Josephson device. FIG. 29 is a plan view illustrating the superconducting circuit according to the third embodiment. FIG. 30 is a cross-sectional view illustrating the superconducting circuit according to the third embodiment. FIG. 29 illustrates some components such as an insulating layer in a transparent manner. FIG. 30 corresponds to a cross-sectional view taken along a line XXX-XXX in FIG. 29.

A superconducting circuit 30 according to the third embodiment mainly includes a substrate 300, a first superconducting metal layer 310, a second superconducting metal layer 320, an insulating layer 330, a third superconducting metal layer 340, a fourth superconducting metal layer 350, and a dielectric layer 390.

The substrate 300 is, for example, a high-resistance Si substrate.

The third superconducting metal layer 340 is formed on the substrate 300. The third superconducting metal layer 340 extends in the X-axis direction parallel to an upper surface of the substrate 300. One end of the third superconducting metal layer 340 has a semicircular arc shape in a plan view. The third superconducting metal layer 340 is, for example, an Al layer having a thickness of 30 nm to 70 nm.

In the vicinity of the semicircular arc end of the third superconducting metal layer 340, the first superconducting metal layer 310 is formed on the third superconducting metal layer 340. The first superconducting metal layer 310 has a substantially truncated cone shape. The first superconducting metal layer 310 is, for example, an Al layer having a thickness of 30 nm to 70 nm. An insulating layer 341 is formed on a surface (an upper surface and a side surface) of the third superconducting metal layer 340 except for a portion where the first superconducting metal layer 310 is formed. The insulating layer 341 is, for example, an Al oxide layer having a thickness of 1 nm to 5 nm.

The insulating layer 330 is formed on a surface (an upper surface and a side surface) of the first superconducting metal layer 310. The insulating layer 330 is, for example, an Al oxide layer having a thickness of 1 nm to 5 nm.

The second superconducting metal layer 320 is formed on a portion of the insulating layer 330 on an upper surface 311 of the first superconducting metal layer 310. A lower surface 322 of the second superconducting metal layer 320 faces the upper surface 311 of the first superconducting metal layer 310, and a part of the insulating layer 330 is provided between the upper surface 311 of the first superconducting metal layer 310 and the lower surface 322 of the second superconducting metal layer 320. In a plan view from a direction perpendicular to the upper surface 311, an outline of the lower surface 322 is inside an outline of the upper surface 311. The second superconducting metal layer 320 has a substantially cylindrical shape. The second superconducting metal layer 320 is, for example, an Al layer having a thickness of 250 nm to 350 nm. The upper surface 311 is an example of the first surface, and the lower surface 322 is an example of the second surface.

A dielectric layer 390 covering the third superconducting metal layer 340, the insulating layer 341, the first superconducting metal layer 310, and the insulating layer 330 is formed on the substrate 300. An upper surface of the dielectric layer 390 is positioned above the lower surface 322 of the second superconducting metal layer 320 and below an upper surface of the second superconducting metal layer 320 in the Z-axis direction perpendicular to the upper surface of the substrate 300. The dielectric layer 390 is, for example, a benzocyclobutene (BCB) layer. An insulating layer 321 is formed on a portion of a side surface of the second superconducting metal layer 320 below the upper surface of the dielectric layer 390. That is, the insulating layer 321 is formed between the second superconducting metal layer 320 and the dielectric layer 390. The insulating layer 321 is, for example, an Al oxide layer having a thickness of 1 nm to 5 nm.

The fourth superconducting metal layer 350 is formed on the dielectric layer 390. The fourth superconducting metal layer 350 is in contact with a portion of the second superconducting metal layer 320 above the upper surface of the dielectric layer 390. The fourth superconducting metal layer 350 extends in the X-axis direction. The fourth superconducting metal layer 350 is, for example, an Al layer having a thickness of 30 nm to 70 nm. An insulating layer 351 is formed on a surface (an upper surface and a side surface) of the fourth superconducting metal layer 350. The insulating layer 351 is, for example, an Al oxide layer having a thickness of 1 nm to 5 nm.

The superconducting circuit 30 according to the present embodiment includes a Josephson device 3 including the first superconducting metal layer 310, the second superconducting metal layer 320, and the insulating layer 330.

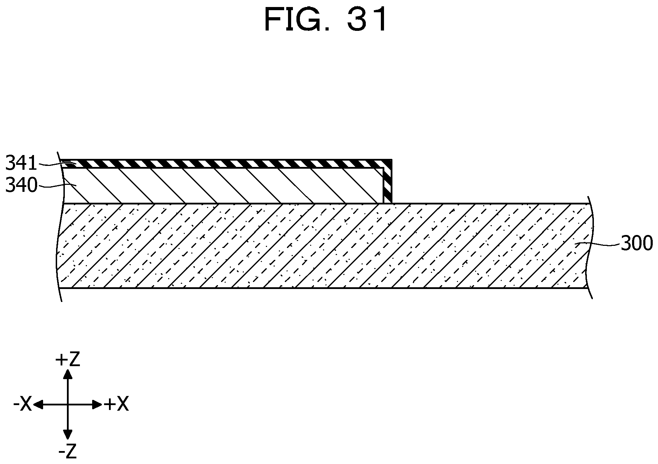

Next, a method for manufacturing the superconducting circuit 30 will be described. FIGs. 31 to 38 are cross-sectional views illustrating the method for manufacturing the superconducting circuit 30 according to the third embodiment.

First, as illustrated in FIG. 31, the third superconducting metal layer 340 is formed on the substrate 300. The third superconducting metal layer 340 may be formed by, for example, vapor deposition and lift-off similarly to the formation of the first superconducting metal layer 110 in the first embodiment, and the like. Film formation of the third superconducting metal layer 340 is performed in vacuum, and when the third superconducting metal layer 340 is exposed to the atmosphere, the insulating layer 341 is formed on the surface of the third superconducting metal layer 340 by natural oxidation.

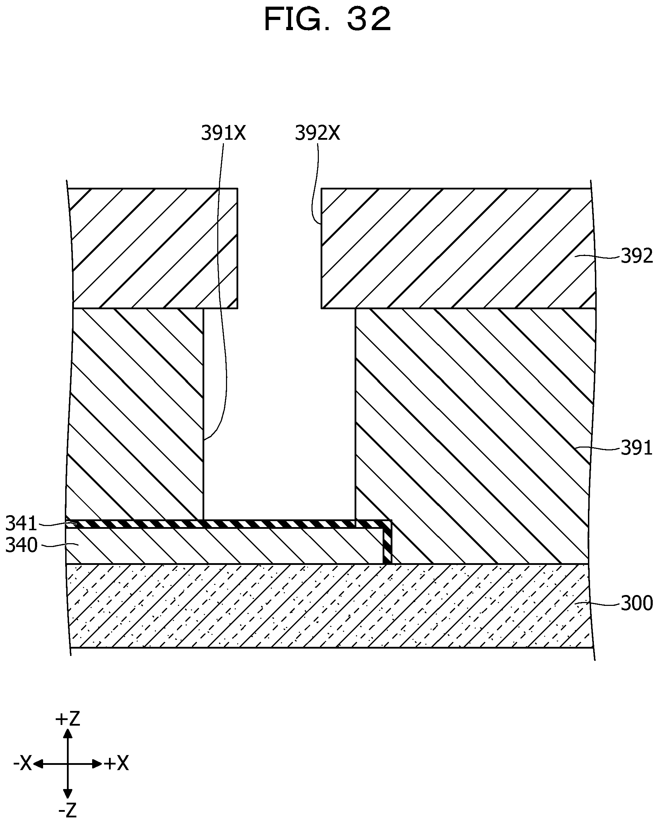

Next, as illustrated in FIG. 32, a resist layer 391 including an opening 391X and a resist layer 392 including an opening 392X are formed on the substrate 300 so as to cover the third superconducting metal layer 340 and the insulating layer 341. For example, the resist layer 391 including the opening 391X and the resist layer 392 including the opening 392X may be formed by performing electron beam exposure after forming the two resist layers. The opening 392X has a shape and a size corresponding to the upper surface of the second superconducting metal layer 320 to be formed in a plan view. The opening 391X has a shape and a size surrounding an outline of a lower surface of the first superconducting metal layer 310 to be formed in a plan view. A part of the insulating layer 341 is exposed from the openings 391X and 392X.

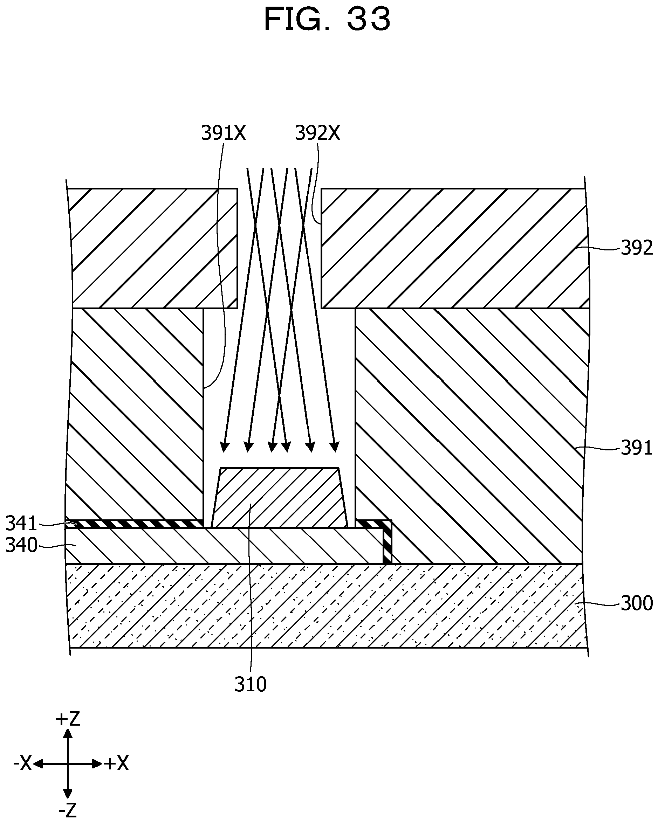

Thereafter, as illustrated in FIG. 33, the portion of the insulating layer 341 exposed from the openings 391X and 392X is removed by ion milling using Ar ions in vacuum. Subsequently, in vacuum, the first superconducting metal layer 310 is formed on a portion of the third superconducting metal layer 340 from which the insulating layer 341 is removed by the vapor deposition method using the resist layers 391 and 392 as vapor deposition masks. At this time, similarly to the formation of the first superconducting metal layer 210 in the second embodiment, the Z-axis direction of the substrate 300 is not parallel to a traveling direction of an evaporation substance (first evaporation substance) emitted from a vapor deposition source, and the substrate 300 is rotated around a straight line passing through a center of the upper surface of the substrate 300 and perpendicular to the upper surface as a rotation center. An inclination angle at this time is such an extent that a portion where the lower surface 322 of the second superconducting metal layer 320 to be formed later is positioned may be seen from the vapor deposition source at any position in the substrate 300. The inclination angle is, for example, about 1° to 10°.

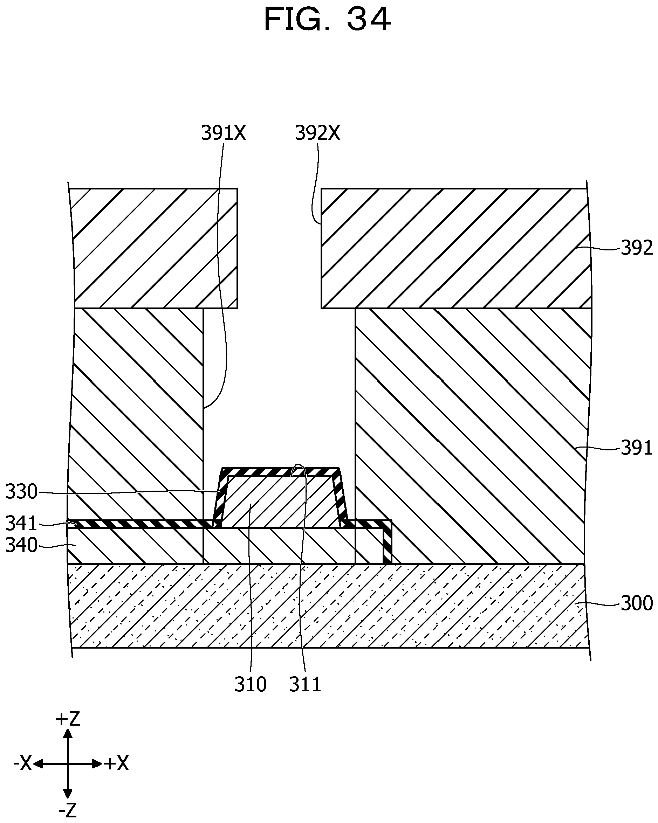

Next, as illustrated in FIG. 34, the surface (the upper surface and the side surface) of the first superconducting metal layer 310 is oxidized to form the insulating layer 330 while leaving the resist layers 391 and 392. In the formation of the insulating layer 330, for example, oxygen is supplied into vacuum without exposure to the atmosphere.

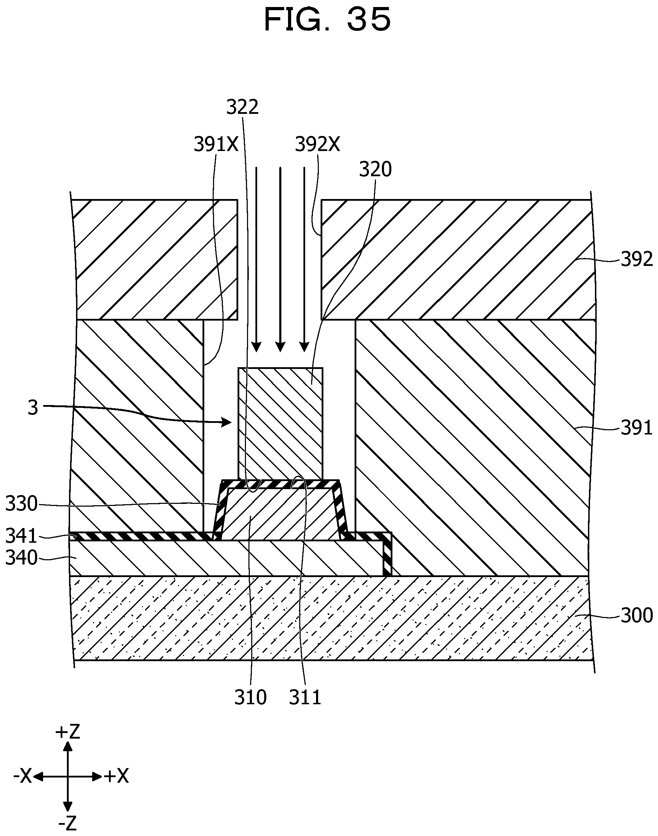

Thereafter, as illustrated in FIG. 35, in vacuum, the second superconducting metal layer 320 is formed on a portion of the insulating layer 330 on the upper surface 311 of the first superconducting metal layer 310 inside the opening 391X by the vapor deposition method using the resist layers 391 and 392 as vapor deposition masks. At this time, similarly to the formation of the second superconducting metal layer 220 in the second embodiment, the Z-axis direction of the substrate 300 is parallel to the traveling direction of the evaporation substance (second evaporation substance).

Preferably, the ion milling of the insulating layer 341, the formation of the first superconducting metal layer 310, the formation of the insulating layer 330, and the formation of the second superconducting metal layer 320 are continuously performed while maintaining a vacuum state in a vacuum chamber.

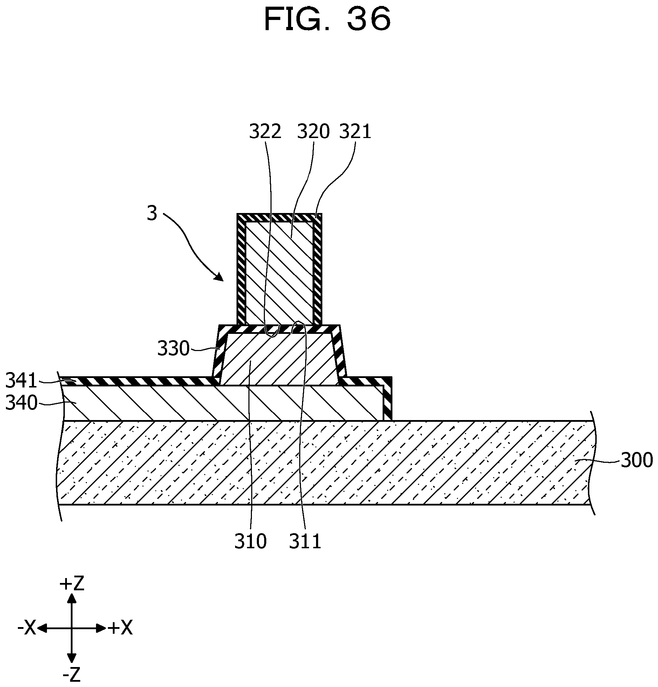

Subsequently, as illustrated in FIG. 36, the resist layers 391 and 392 are removed. Although not illustrated, at the time of the formation of the first superconducting metal layer 310 and at the time of the formation of the second superconducting metal layer 320, the evaporation substance is deposited also on the resist layer 392, but the deposited evaporation substance is removed together with the resist layers 391 and 392. That is, lift-off is performed. Furthermore, when the second superconducting metal layer 320 is exposed to the atmosphere, the insulating layer 321 is formed on the surface of the second superconducting metal layer 320 by natural oxidation.

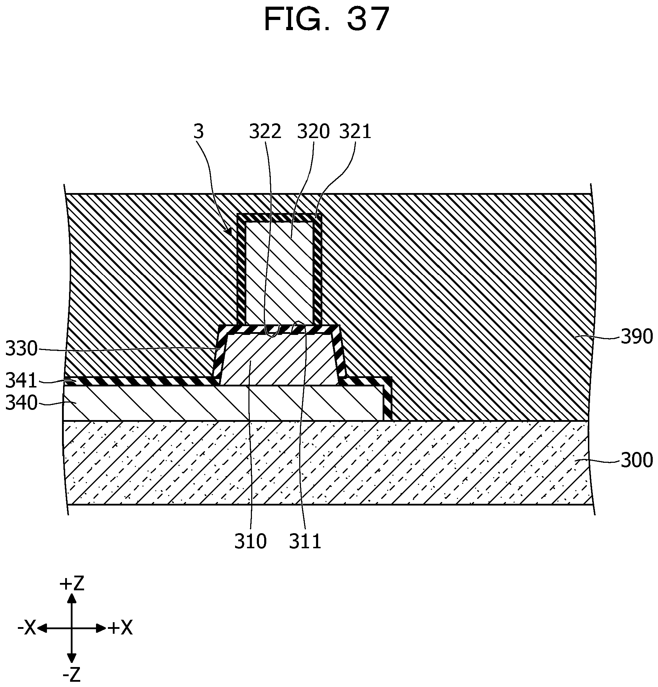

Next, as illustrated in FIG. 37, the dielectric layer 390 covering the third superconducting metal layer 340, the insulating layer 341, the first superconducting metal layer 310, the insulating layer 330, the second superconducting metal layer 320, and the insulating layer 321 is formed on the substrate 300. The upper surface of the dielectric layer 390 is positioned above the upper surface of the second superconducting metal layer 320 in the Z-axis direction. In the formation of the dielectric layer 390, for example, spin coating of a BCB resin is performed, and then the BCB resin is thermally cured.

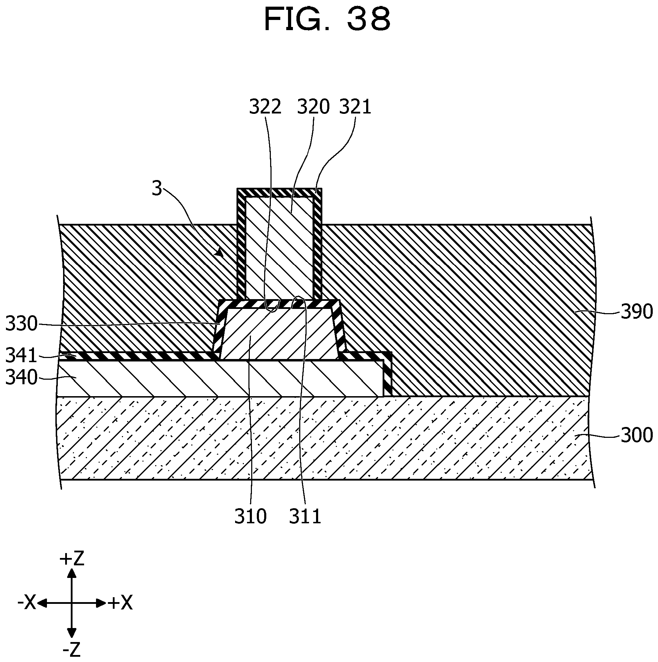

Thereafter, as illustrated in FIG. 38, the dielectric layer 390 is etched back by dry etching, and the upper surface of the dielectric layer 390 is positioned below the upper surface of the second superconducting metal layer 320. That is, a part of the second superconducting metal layer 320 protrudes from the dielectric layer 390.

Subsequently, in vacuum, the insulating layer 321 formed on a surface of the portion of the second superconducting metal layer 320 protruding from the dielectric layer 390 is removed, and the fourth superconducting metal layer 350 in contact with the portion of the second superconducting metal layer 320 above the upper surface of the dielectric layer 390 is formed on the dielectric layer 390 (see FIG. 30). The insulating layer 321 may be removed by ion milling using Ar ions. The fourth superconducting metal layer 350 may be formed by, for example, vapor deposition and lift-off similarly to the formation of the third superconducting metal layer 340, and the like. When the fourth superconducting metal layer 350 is exposed to the atmosphere, the insulating layer 351 is formed on the surface of the fourth superconducting metal layer 350 by natural oxidation.

In this manner, the superconducting circuit 30 according to the third embodiment may be manufactured.

In the present embodiment, the outline of the lower surface 322 of the second superconducting metal layer 320 is inside the outline of the upper surface 311 of the first superconducting metal layer 310 in a plan view. Therefore, the inclination angle at the time of the formation of the first superconducting metal layer 310 may be reduced, and the Z-axis direction of the substrate 300 may be made parallel to the traveling direction of the evaporation substance at the time of the formation of the second superconducting metal layer 320. Therefore, similarly to the first embodiment, it is possible to suppress a difference in incident angle of the evaporation substance to the substrate 300.

Therefore, a difference in shape among a plurality of the Josephson devices 3 formed on the substrate 300 is slight, and it is possible to suppress variations in characteristics of the Josephson devices 3.

Moreover, the third superconducting metal layer 340 in contact with the first superconducting metal layer 310 and the fourth superconducting metal layer 350 in contact with the second superconducting metal layer 320 may be used as wirings coupled to the Josephson device 3.

### (Fourth Embodiment)

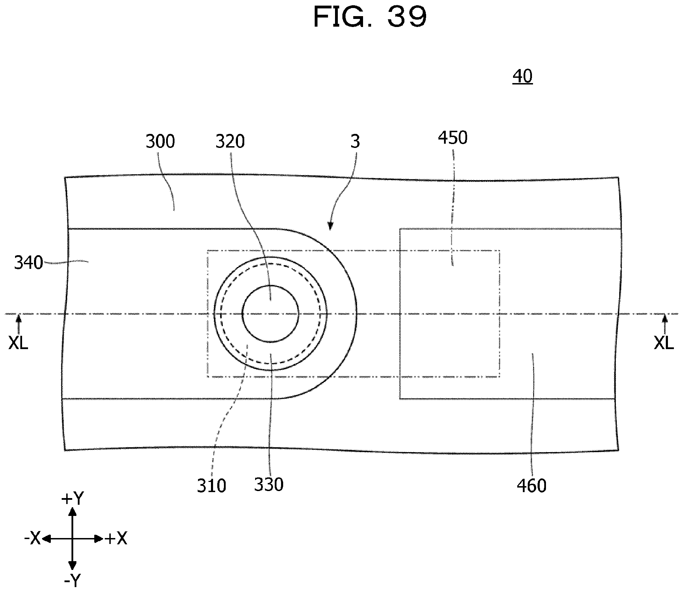

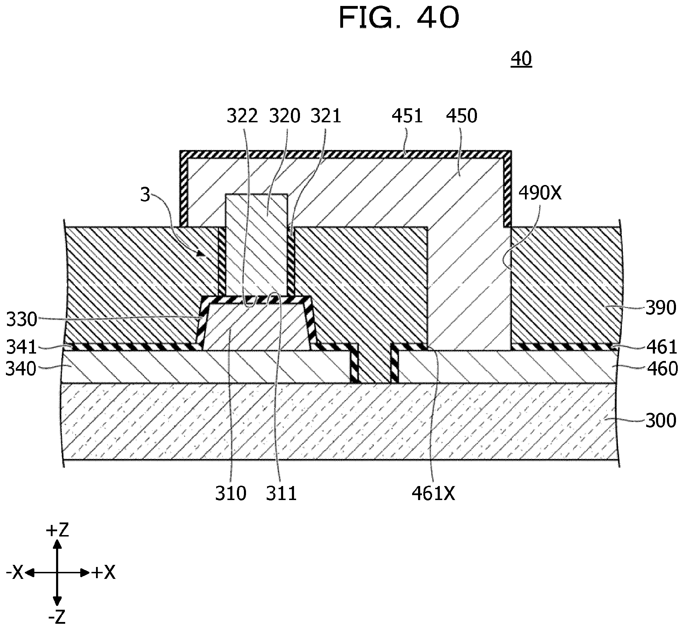

A fourth embodiment will be described. The fourth embodiment also relates to a superconducting circuit including a Josephson device. FIG. 39 is a plan view illustrating the superconducting circuit according to the fourth embodiment. FIG. 40 is a cross-sectional view illustrating the superconducting circuit according to the fourth embodiment. FIG. 39 illustrates some components such as an insulating layer in a transparent manner. FIG. 40 corresponds to a cross-sectional view taken along a line XL-XL in FIG. 39.

A superconducting circuit 40 according to the fourth embodiment mainly includes a substrate 300, a first superconducting metal layer 310, a second superconducting metal layer 320, an insulating layer 330, a third superconducting metal layer 340, a fourth superconducting metal layer 450, a fifth superconducting metal layer 460, and a dielectric layer 390.

The fifth superconducting metal layer 460 is formed on the substrate 300. Similarly to the third superconducting metal layer 340, the fifth superconducting metal layer 460 extends in the X-axis direction parallel to an upper surface of the substrate 300. The fifth superconducting metal layer 460 is disposed on the +X side of the third superconducting metal layer 340 away from the third superconducting metal layer 340. The fifth superconducting metal layer 460 is, for example, an Al layer having a thickness of 30 nm to 70 nm. An insulating layer 461 is formed on a surface (an upper surface and a side surface) of the fifth superconducting metal layer 460. The insulating layer 461 is, for example, an Al oxide layer having a thickness of 1 nm to 5 nm. An opening 461X overlapping a part of the fifth superconducting metal layer 460 in a plan view is formed in the insulating layer 461.

The dielectric layer 390 also covers the fifth superconducting metal layer 460 and the insulating layer 461. An opening 490X overlapping the opening 461X in a plan view is formed in the dielectric layer 390.

The fourth superconducting metal layer 450 is formed on the dielectric layer 390 and inside the openings 490X and 461X. The fourth superconducting metal layer 450 is in contact with a portion of the second superconducting metal layer 320 above an upper surface of the dielectric layer 390 and the fifth superconducting metal layer 460. The fourth superconducting metal layer 450 is, for example, an Al layer. A thickness of a portion on the dielectric layer 390 of the fourth superconducting metal layer 450 is, for example, 30 nm to 70 nm. An insulating layer 451 is formed on a surface (an upper surface and a side surface) of the fourth superconducting metal layer 450. The insulating layer 451 is, for example, an Al oxide layer having a thickness of 1 nm to 5 nm.

Other components are similar to those of the third embodiment.

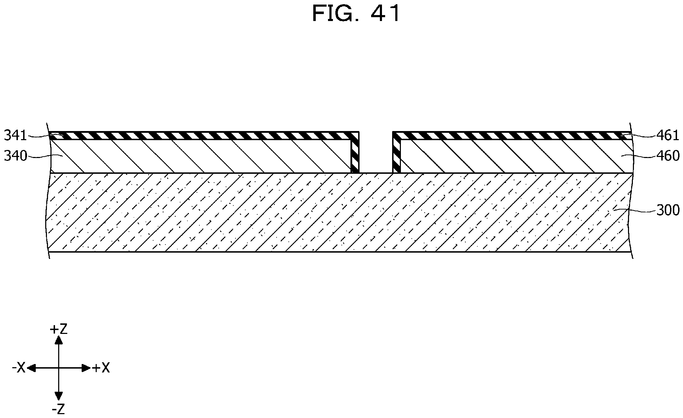

Next, a method for manufacturing the superconducting circuit 40 will be described. FIGs. 41 to 43 are cross-sectional views illustrating the method for manufacturing the superconducting circuit 40 according to the fourth embodiment.

First, as illustrated in FIG. 41, the third superconducting metal layer 340 and the fifth superconducting metal layer 460 are formed on the substrate 300. The third superconducting metal layer 340 and the fifth superconducting metal layer 460 may be formed by, for example, vapor deposition and lift-off similarly to the formation of the first superconducting metal layer 110 in the first embodiment, and the like. Film formation of the third superconducting metal layer 340 and the fifth superconducting metal layer 460 is performed in vacuum, and when the third superconducting metal layer 340 and the fifth superconducting metal layer 460 are exposed to the atmosphere, an insulating layer 341 is formed on a surface of the third superconducting metal layer 340 and the insulating layer 461 is formed on the surface of the fifth superconducting metal layer 460 by natural oxidation.

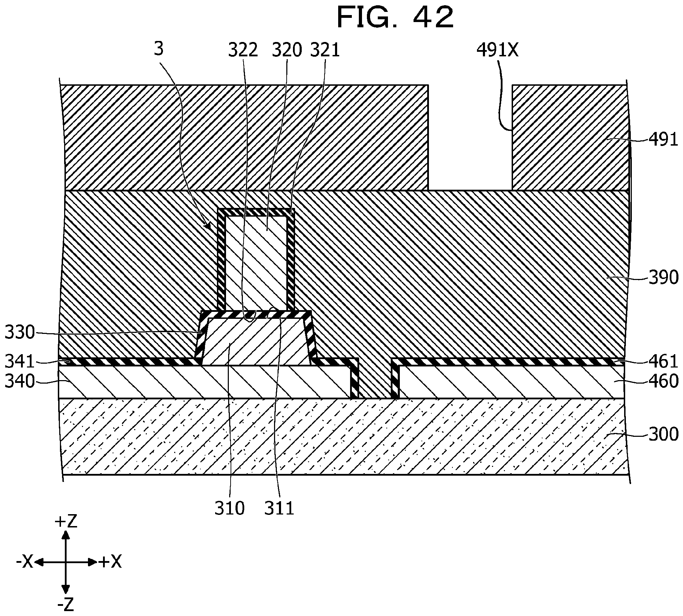

Next, as illustrated in FIG. 42, processing from formation of resist layers 391 and 392 to formation of the dielectric layer 390 is performed similarly to the third embodiment. Thereafter, a resist layer 491 including an opening 491X is formed on the dielectric layer 390. The opening 491X has a shape and a size corresponding to the opening 490X in Fig. 40 to be formed in a plan view.

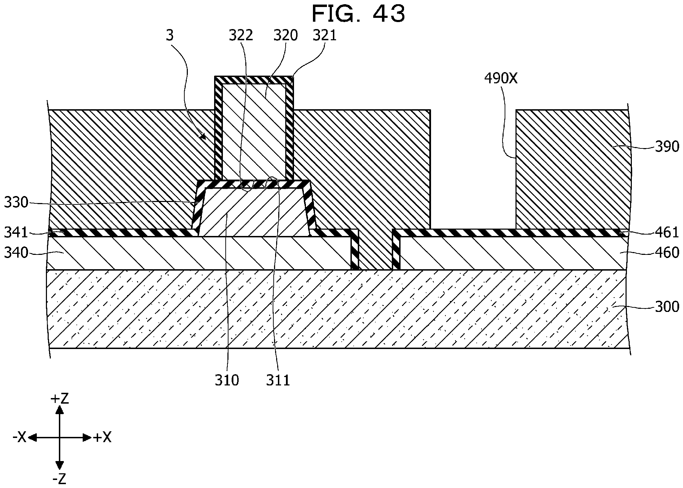

Subsequently, as illustrated in FIG. 43, the resist layer 491 and the dielectric layer 390 are etched back by dry etching, and the opening 490X is formed in the dielectric layer 390 while the upper surface of the dielectric layer 390 is positioned below an upper surface of the second superconducting metal layer 320. The resist layer 491 is removed by etching back.

Next, in vacuum, the insulating layer 321 formed on a surface of a portion of the second superconducting metal layer 320 protruding from the dielectric layer 390 and the insulating layer 461 exposed from the opening 490X are removed. The opening 461X is formed in the insulating layer 461. Then, the fourth superconducting metal layer 450 in contact with the portion of the second superconducting metal layer 320 above the upper surface of the dielectric layer 390 and the fifth superconducting metal layer 460 is formed (see FIG. 40). The insulating layers 321 and 461 may be removed by ion milling using Ar ions. The fourth superconducting metal layer 450 may be formed by, for example, vapor deposition and lift-off similarly to the formation of the third superconducting metal layer 340 and the fifth superconducting metal layer 460, and the like. When the fourth superconducting metal layer 450 is exposed to the atmosphere, the insulating layer 451 is formed on the surface of the fourth superconducting metal layer 450 by natural oxidation.

In this manner, the superconducting circuit 40 according to the fourth embodiment may be manufactured.

Also in the present embodiment, a difference in shape among a plurality of Josephson devices 3 formed on the substrate 300 is slight, and it is possible to suppress variations in characteristics of the Josephson devices 3.

Moreover, the third superconducting metal layer 340 in contact with the first superconducting metal layer 310, the fourth superconducting metal layer 450 in contact with the second superconducting metal layer 320, and the fifth superconducting metal layer 460 in contact with the fourth superconducting metal layer 450 may be used as wirings coupled to the Josephson device 3.

### (Fifth Embodiment)

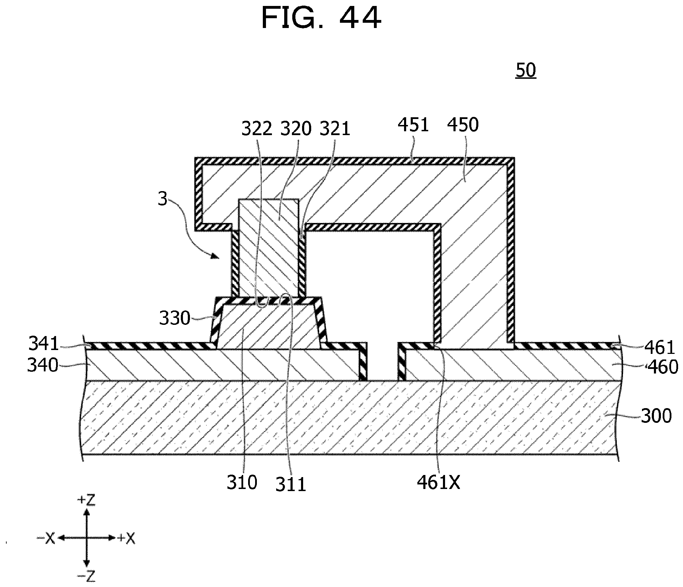

A fifth embodiment will be described. The fifth embodiment also relates to a superconducting circuit including a Josephson device. FIG. 44 is a cross-sectional view illustrating the superconducting circuit according to the fifth embodiment. Similarly to FIG. 40, FIG. 44 corresponds to a cross-sectional view taken along the line XL-XL in FIG. 39.

A superconducting circuit 50 according to the fifth embodiment mainly includes a substrate 300, a first superconducting metal layer 310, a second superconducting metal layer 320, an insulating layer 330, a third superconducting metal layer 340, a fourth superconducting metal layer 450, and a fifth superconducting metal layer 460. A dielectric layer 390 is not provided in the superconducting circuit 50. An insulating layer 451 is formed on substantially an entire side surface of the fourth superconducting metal layer 450 so as to be coupled to an insulating layer 461.

Other components are similar to those of the fourth embodiment.

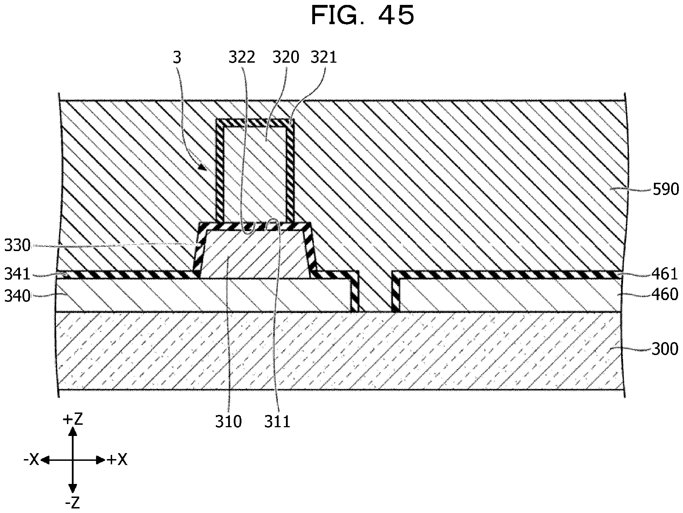

Next, a method for manufacturing the superconducting circuit 50 will be described. FIGs. 45 to 48 are cross-sectional views illustrating the method for manufacturing the superconducting circuit 50 according to the fifth embodiment.

First, as illustrated in FIG. 45, resist layers 391 and 392 are removed similarly to the fourth embodiment. Next, a sacrificial layer 590 covering the third superconducting metal layer 340, an insulating layer 341, the first superconducting metal layer 310, the insulating layer 330, the second superconducting metal layer 320, and an insulating layer 321 is formed on the substrate 300. An upper surface of the sacrificial layer 590 is positioned above an upper surface of the second superconducting metal layer 320 in the Z-axis direction. In the formation of the sacrificial layer 590, for example, spin coating of a polymethylglutarimide (PMGI) resin is performed, and then the PMGI resin is thermally cured.

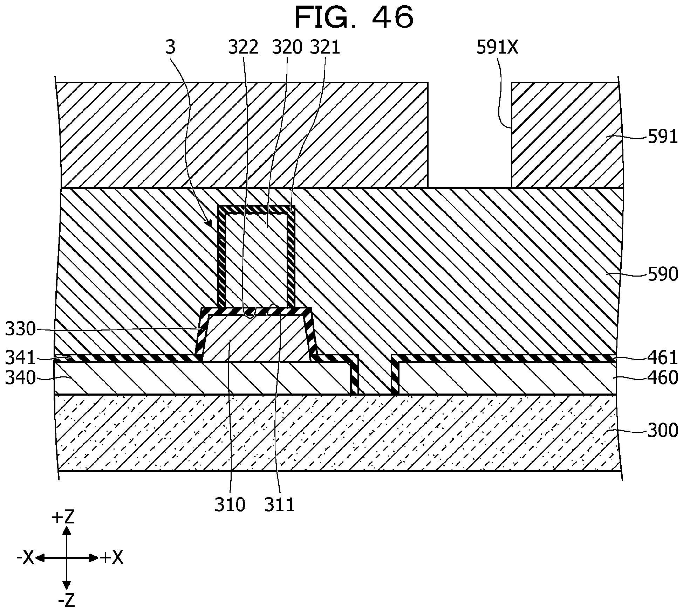

Thereafter, as illustrated in FIG. 46, a resist layer 591 including an opening 591X is formed on the sacrificial layer 590. The opening 591X has a shape and a size corresponding to a portion extending in the Z-axis direction of the fourth superconducting metal layer 450 to be formed later in a plan view.

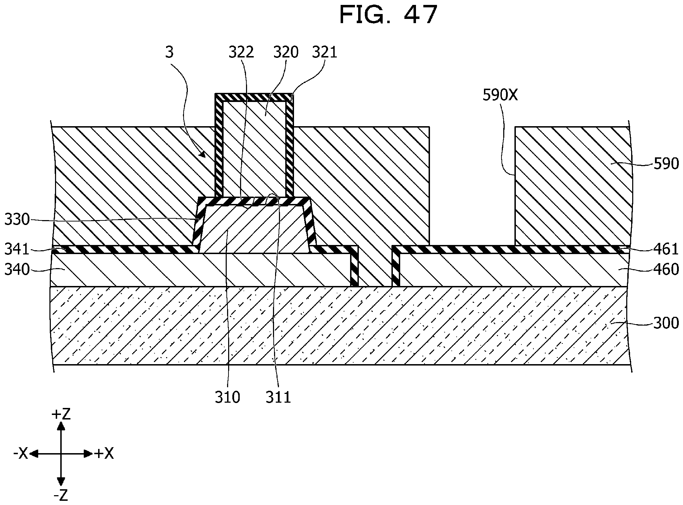

Subsequently, as illustrated in FIG. 47, the resist layer 591 and the sacrificial layer 590 are etched back by dry etching, and an opening 590X is formed in the sacrificial layer 590 while the upper surface of the sacrificial layer 590 is positioned below the upper surface of the second superconducting metal layer 320. The resist layer 591 is removed by etching back.

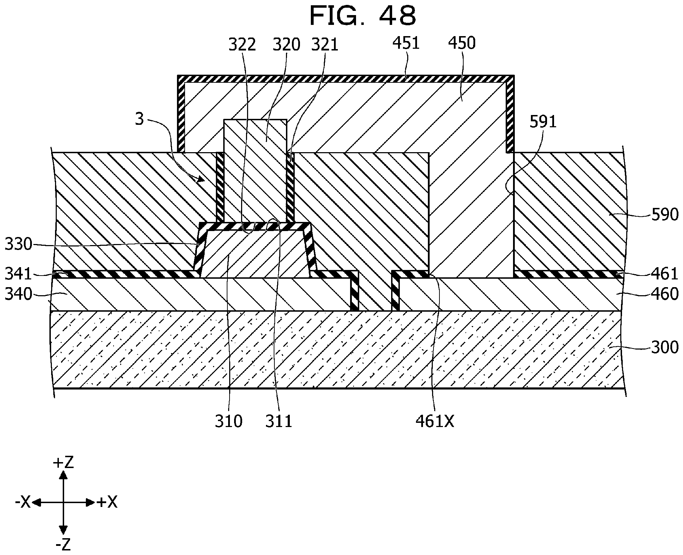

Next, as illustrated in FIG. 48, in vacuum, the insulating layer 321 formed on a surface of a portion of the second superconducting metal layer 320 protruding from the sacrificial layer 590 and the insulating layer 461 exposed from the opening 590X are removed. The opening 461X is formed in the insulating layer 461. Then, the fourth superconducting metal layer 450 in contact with the portion of the second superconducting metal layer 320 above the upper surface of the sacrificial layer 590 and the fifth superconducting metal layer 460 is formed. When the fourth superconducting metal layer 450 is exposed to the atmosphere, the insulating layer 451 is formed on a surface of the fourth superconducting metal layer 450 by natural oxidation.

Thereafter, the sacrificial layer 590 is dissolved and removed using a solvent (see FIG. 44).

In this manner, the superconducting circuit 50 according to the fifth embodiment may be manufactured.

Also in the present embodiment, a difference in shape among a plurality of Josephson devices 3 formed on the substrate 300 is slight, and it is possible to suppress variations in characteristics of the Josephson devices 3.

In general, since a dielectric includes a defect called a two-level system (TLS), when the dielectric exists in the vicinity of a Josephson device, it is difficult to extend a coherence time. On the other hand, in the present embodiment, the superconducting circuit 50 has an air bridge structure, and the dielectric layer 390 is not provided around the Josephson device 3. Therefore, according to the present embodiment, a coherence time of the Josephson device 3 may be extended, and the present embodiment is suitable for a quantum operation.

### (Sixth Embodiment)

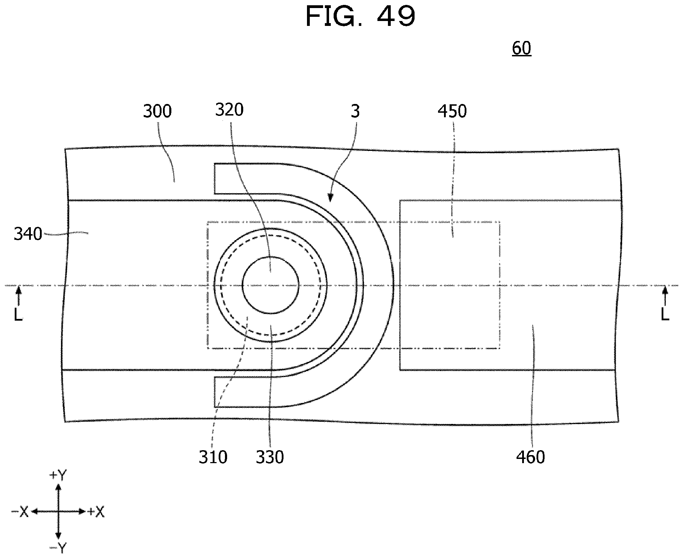

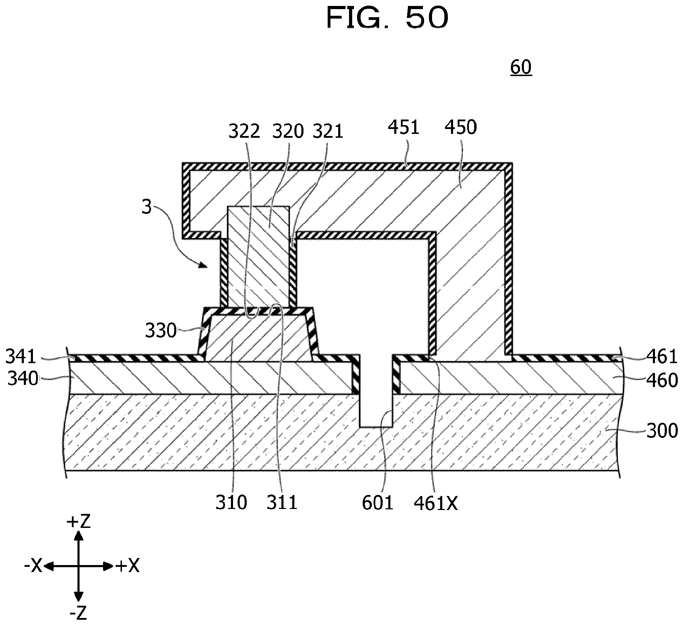

A sixth embodiment will be described. The sixth embodiment also relates to a superconducting circuit including a Josephson device. FIG. 49 is a plan view illustrating the superconducting circuit according to the sixth embodiment. FIG. 50 is a cross-sectional view illustrating the superconducting circuit according to the sixth embodiment. FIG. 50 corresponds to a cross-sectional view taken along a line L-L in FIG. 49.

In a superconducting circuit 60 according to the sixth embodiment, a trench 601 is formed on a surface of a substrate 300 along edges of a third superconducting metal layer 340 and an insulating layer 341 around a Josephson device 3. For example, the trench 601 is formed along the edge of the insulating layer 341 formed on an end of the third superconducting metal layer 340 having a semicircular arc shape in a plan view and a side surface of the end. A depth of the trench 601 is, for example, 50 nm to 200 nm.

Other components are similar to those of the fifth embodiment.

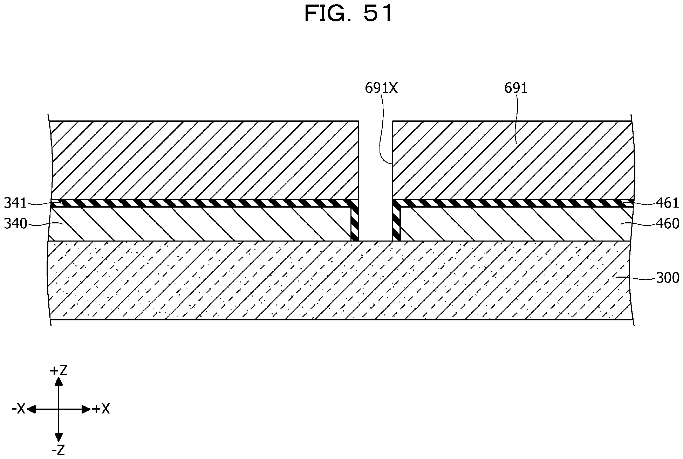

Next, a method for manufacturing the superconducting circuit 60 will be described. FIGs. 51 to 53 are cross-sectional views illustrating the method for manufacturing the superconducting circuit 60 according to the sixth embodiment.

First, as illustrated in FIG. 51, similarly to the fourth embodiment, the third superconducting metal layer 340 and a fifth superconducting metal layer 460 are formed on the substrate 300. When the third superconducting metal layer 340 and the fifth superconducting metal layer 460 are exposed to the atmosphere, the insulating layer 341 is formed on a surface of the third superconducting metal layer 340 and an insulating layer 461 is formed on a surface of the fifth superconducting metal layer 460 by natural oxidation. Next, a resist layer 691 including an opening 691X is formed on the substrate 300 so as to cover the third superconducting metal layer 340, the insulating layer 341, the fifth superconducting metal layer 460, and the insulating layer 461. The opening 691X has a shape and a size corresponding to the trench 601 to be formed in a plan view.

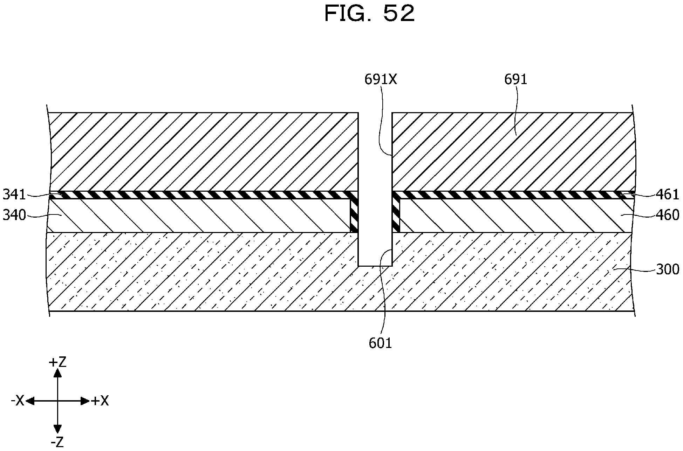

Thereafter, as illustrated in FIG. 52, the trench 601 is formed on the surface of the substrate 300 by dry etching using the resist layer 691 as an etching mask.

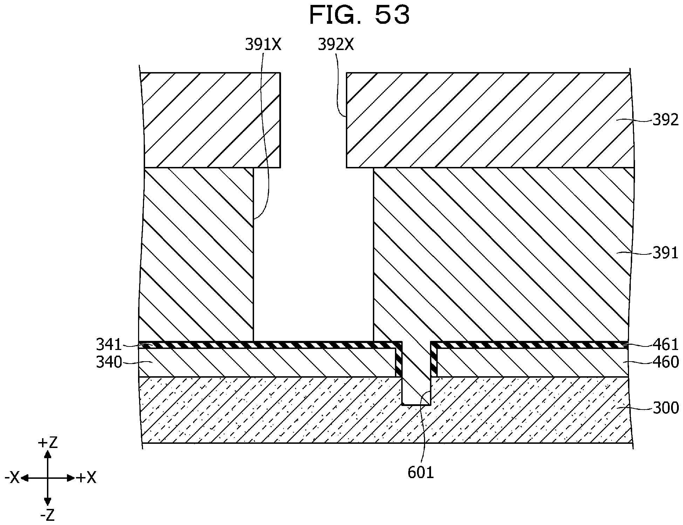

Subsequently, as illustrated in FIG. 53, the resist layer 691 is removed, and a resist layer 391 including an opening 391X and a resist layer 392 including an opening 392X are formed on the substrate 300, similarly to the fifth embodiment. At this time, the resist layer 391 is also formed inside the trench 601.

Next, processing from removal of the insulating layer 341 to removal of a sacrificial layer 590 is performed similarly to the fifth embodiment (see FIG. 50).

In this manner, the superconducting circuit 60 according to the sixth embodiment may be manufactured.

Also in the present embodiment, a difference in shape among a plurality of the Josephson devices 3 formed on the substrate 300 is slight, and it is possible to suppress variations in characteristics of the Josephson devices 3.

Moreover, since the trench 601 is formed on the surface of the substrate 300, a distance from the TLS existing on the surface of the substrate 300 of the Josephson device 3 may be increased to reduce a dielectric loss. Therefore, a coherence time of the Josephson device 3 may be further extended.

### (Seventh Embodiment)

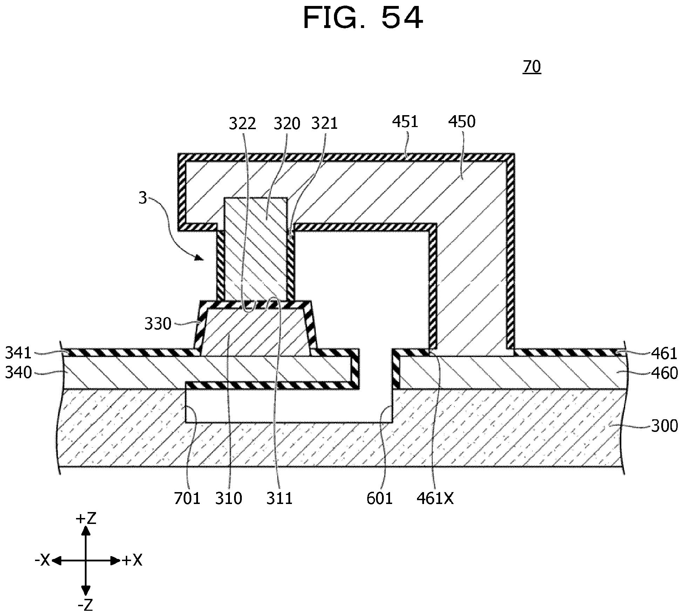

A seventh embodiment of the invention according to claim 1 will be described. The seventh embodiment also relates to a superconducting circuit including a Josephson device. FIG. 54 is a cross-sectional view illustrating the superconducting circuit according to the seventh embodiment. Similarly to FIG. 50, FIG. 54 corresponds to a cross-sectional view taken along the line L-L in FIG. 49.

Similarly to the sixth embodiment, in a superconducting circuit 70 according to the seventh embodiment, a trench 601 is formed on a surface of a substrate 300 along edges of a third superconducting metal layer 340 and an insulating layer 341 around a Josephson device 3. Moreover, a recess 701 coupled to the trench 601 is formed on the surface of the substrate 300 below the Josephson device 3. Therefore, a space exists between the third superconducting metal layer 340 and the substrate 300. Furthermore, the insulating layer 341 is formed also on a lower surface (a surface on a -Z side) of the third superconducting metal layer 340. A depth of the trench 601 and the recess 701 is, for example, 50 nm to 200 nm.

Other components are similar to those of the sixth embodiment.

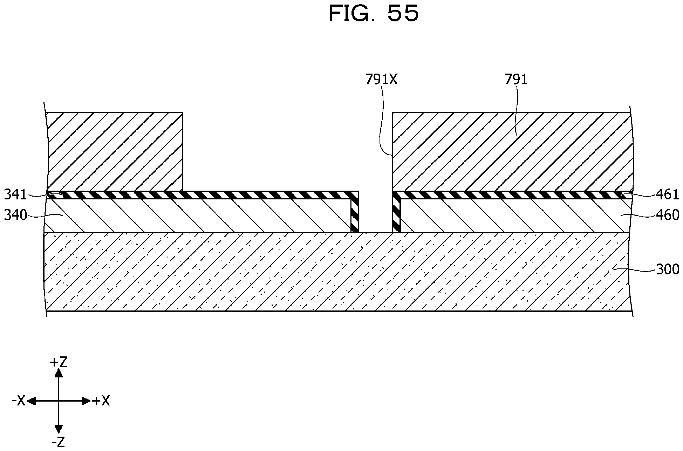

Next, a method for manufacturing the superconducting circuit 70 will be described. FIGs. 55 to 57 are cross-sectional views illustrating the method for manufacturing the superconducting circuit 70 according to the seventh embodiment.

First, as illustrated in FIG. 55, similarly to the fourth embodiment, the third superconducting metal layer 340 and a fifth superconducting metal layer 460 are formed on the substrate 300. When the third superconducting metal layer 340 and the fifth superconducting metal layer 460 are exposed to the atmosphere, the insulating layer 341 is formed on a surface of the third superconducting metal layer 340 and an insulating layer 461 is formed on a surface of the fifth superconducting metal layer 460 by natural oxidation. Next, a resist layer 791 including an opening 791X is formed on the substrate 300 so as to cover the third superconducting metal layer 340, the insulating layer 341, the fifth superconducting metal layer 460, and the insulating layer 461. The opening 791X has a shape and a size corresponding to the trench 601 and the recess 701 to be formed in a plan view.

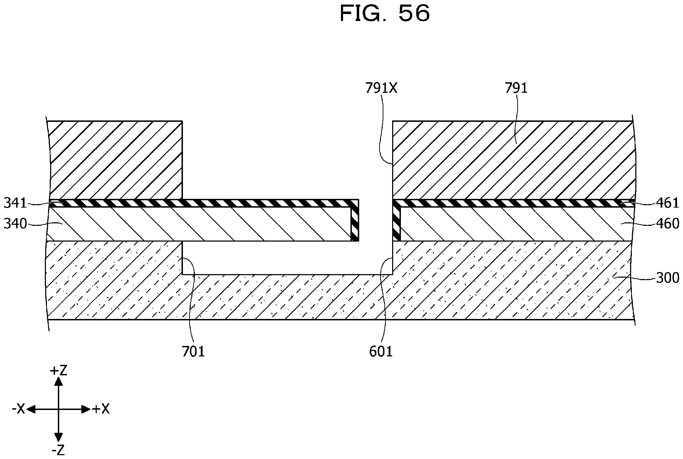

Thereafter, as illustrated in FIG. 56, the trench 601 and the recess 701 are formed on the surface of the substrate 300 by dry etching using the resist layer 791 as an etching mask. For example, by making a dry etching pressure higher than that at the time of the formation of the trench 601 in the sixth embodiment, side etching of the substrate 300 may be easily caused.

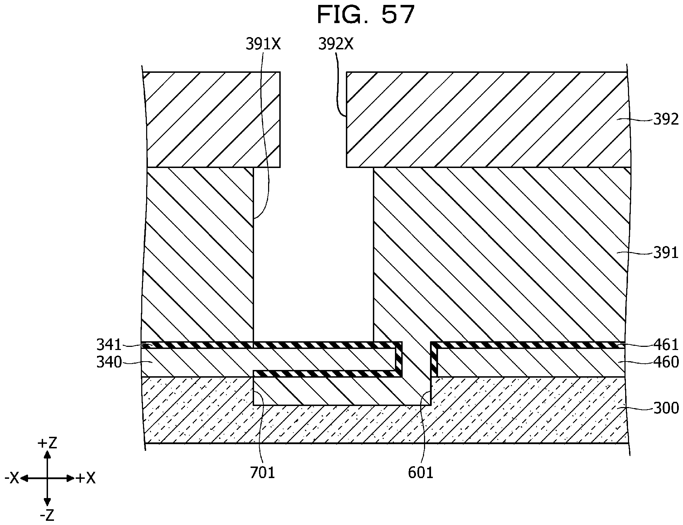

Subsequently, as illustrated in FIG. 57, the resist layer 791 is removed, and a resist layer 391 including an opening 391X and a resist layer 392 including an opening 392X are formed on the substrate 300, similarly to the fifth embodiment. At this time, the resist layer 391 is also formed inside the trench 601 and the recess 701. Furthermore, when the third superconducting metal layer 340 is exposed to the atmosphere after the formation of the recess 701, the insulating layer 341 is formed also on the lower surface of the third superconducting metal layer 340 by natural oxidation.

Next, processing from removal of the insulating layer 341 to removal of a sacrificial layer 590 is performed similarly to the fifth embodiment (see FIG. 54).

In this manner, the superconducting circuit 70 according to the seventh embodiment may be manufactured.

Also in the present embodiment, a difference in shape among a plurality of the Josephson devices 3 formed on the substrate 300 is slight, and it is possible to suppress variations in characteristics of the Josephson devices 3.

Moreover, since not only the trench 601 but also the recess 701 is formed on the surface of the substrate 300, a dielectric loss may be further reduced. Therefore, a coherence time of the Josephson device 3 may be still further extended.

In each embodiment, a material of the superconducting metal layer is not particularly limited. For example, the material of the superconducting metal layer may be Al, Nb, Nb nitride, Ta, Ta nitride, Ti nitride, or the like. That is, the superconducting metal layer may include Al, Nb, Nb nitride, Ta, Ta nitride, Ti nitride, or the like. For example, in the fifth embodiment, the third superconducting metal layer 340 and the fifth superconducting metal layer 460 may be Nb layers.

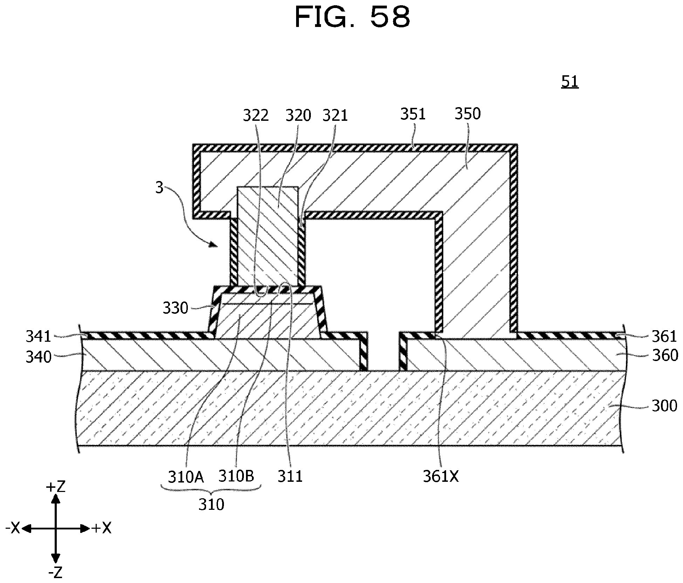

Furthermore, each superconducting metal layer may have a stacked structure. FIG. 58 is a cross-sectional view illustrating a superconducting circuit according to a modification of the fifth embodiment. For example, as illustrated in FIG. 58, in a superconducting circuit 51 according to the modification of the fifth embodiment, the first superconducting metal layer 310 includes a sixth superconducting metal layer 310A in contact with the third superconducting metal layer 340 and a seventh superconducting metal layer 310B on the sixth superconducting metal layer 310A. For example, the sixth superconducting metal layer 310A is an Al layer, and the seventh superconducting metal layer 310B is an Nb layer. Furthermore, the third superconducting metal layer 340 and the fifth superconducting metal layer 460 may be Ti nitride layers, and the fourth superconducting metal layer 350 may be a Ta layer.

### (Eighth Embodiment)

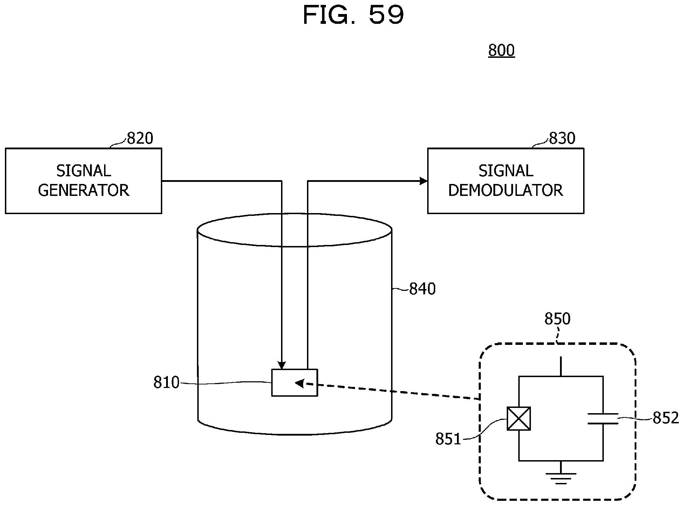

An eighth embodiment will be described. The eighth embodiment relates to a quantum operation device including a Josephson device. FIG. 59 is a diagram illustrating the quantum operation device according to the eighth embodiment.

A quantum operation device 800 according to the eighth embodiment includes a qubit chip 810, a signal generator 820, a signal demodulator 830, and a cryogenic dilution refrigerator 840, as illustrated in FIG. 59. The qubit chip 810 is housed in the cryogenic dilution refrigerator 840, and is cooled to a temperature equal to or lower than 10 mK. The signal generator 820 generates a microwave pulse signal, and the microwave pulse signal is input to the qubit chip 810. The qubit chip 810 outputs a signal according to the microwave pulse signal, and the signal demodulator 830 demodulates the signal output from the qubit chip 810. The signal generator 820 and the signal demodulator 830 are used at, for example, a temperature of about room temperature.

The qubit chip 810 includes a plurality of superconducting qubits 850, and each superconducting qubit 850 includes a Josephson device 851 and a capacitor 852 electrically coupled in parallel to the Josephson device 851. The Josephson device 851 is the Josephson device 3 in any one of the third to seventh embodiments, and a wiring of the third superconducting metal layer and a wiring of the fourth or fifth superconducting metal layer are coupled to the capacitor 852.

Since the Josephson device 851 included in the quantum operation device 800 according to the eighth embodiment is the Josephson device 3 in any one of the third to seventh embodiments, variations in characteristics among the plurality of Josephson devices 3 are suppressed, and calculation excellent in reliability may be performed.

Although the preferred embodiments and the like have been described in detail above, the present disclosure is not limited to the embodiments and the like described above, and various modifications and substitutions may be made to the embodiments and the like described above without departing from the scope described in the claims.

### REFERENCE SIGNS LIST

- 1, 2, 3: Josephson device
- 110, 210, 310: First superconducting metal layer
- 111, 211, 311: Upper surface
- 120, 220, 320: Second superconducting metal layer
- 122, 222, 322: Lower surface
- 130, 230, 330: Insulating layer
- 300: Substrate
- 340: Third superconducting metal layer
- 350, 450: Fourth superconducting metal layer
- 460: Fifth superconducting metal layer
- 800: Quantum operation device
- 810: Qubit chip
- 850: Superconducting qubit
- 851: Josephson device

## Claims

1. A superconducting circuit (70) comprising:
a substrate (300);
a third superconducting metal layer (340) formed on the substrate;
a Josephson device (3), which includes a first superconducting metal layer (310) that includes a first surface (311), a second superconducting metal layer (320) that includes a second surface (322) that faces the first surface, and an insulating layer (330) provided between the first surface and the second surface, and is formed on the third superconducting metal layer, and in which the first superconducting metal layer is in contact with the third superconducting metal layer; and
a fourth superconducting metal layer (450) coupled to the second superconducting metal layer,
wherein an outline of the second surface is inside an outline of the first surface in a plan view from a direction perpendicular to the first surface, and
wherein a recess (701) is formed on a surface of the substrate below the Josephson device, and a space exists between the third superconducting metal layer and the substrate.

2. The superconducting circuit according to claim 1, wherein a periphery of the Josephson device is hollow.

3. The superconducting circuit according to claim 1, further comprising a dielectric layer (390) that surrounds a periphery of the Josephson device.

4. The superconducting circuit according to any preceding claim, further comprising
a fifth superconducting metal layer (460) formed on the substrate (300),
wherein the fourth superconducting metal layer (450) is in contact with the second superconducting metal layer (320) and the fifth superconducting metal layer.

5. The superconducting circuit according to claim 4, wherein the fifth superconducting metal layer (460) includes Al, Nb, Nb nitride, Ta, Ta nitride, or Ti nitride.

6. The superconducting circuit according to any preceding claim, wherein a trench (601) is formed in a region around the Josephson device in a plan view of a surface of the substrate (300).

7. The superconducting circuit according to any preceding claim, wherein the third superconducting metal layer (340) and the fourth superconducting metal layer (450) include Al, Nb, Nb nitride, Ta, Ta nitride, or Ti nitride.

8. The superconducting circuit according to any preceding claim, wherein
the first surface and the second surface have a circular shape, and
a diameter of the second surface is smaller than a diameter of the first surface.

9. The superconducting circuit according to any preceding claim, wherein the first superconducting metal layer (310) and the second superconducting metal layer (320) include Al, Nb, Nb nitride, Ta, Ta nitride, or Ti nitride.

10. A quantum operation device (800) comprising the superconducting circuit according to any preceding claim.

11. A method for manufacturing a Josephson device (1, 2), comprising:
forming a mask (191, 192, 291, 292) that includes an opening on a substrate (100);
forming a first superconducting metal layer (110, 210) that has a first surface (111, 211) on the substrate through the opening by supplying a first evaporation substance toward an upper surface of the substrate;
forming an insulating layer (130, 230) by oxidizing the first surface of the first superconducting metal layer; and
forming a second superconducting metal layer (120, 220) that has a second surface (122, 222) that faces the first surface on the insulating layer through the opening by supplying a second evaporation substance toward the upper surface,
wherein, in the forming of the second superconducting metal layer, the second evaporation substance is supplied such that an outline of the second surface is positioned inside an outline of the first surface in a plan view from a direction perpendicular to the first surface.

12. The method for manufacturing a Josephson device according to claim 11, wherein
the forming of the first superconducting metal layer (210) includes:
rotating the substrate (100) around a straight line that passes through a center of the upper surface and is perpendicular to the upper surface as a rotation center; and
supplying the first evaporation substance from a direction inclined from the straight line toward the upper surface.

13. The method for manufacturing a Josephson device according to claim 11 or 12, wherein the forming of the first superconducting metal layer (110, 210), the forming of the insulating layer (130, 230), and the forming of the second superconducting metal layer (120, 220) are performed while a vacuum state is maintained in a vacuum chamber.

## Patentansprüche

1. Supraleitende Schaltung (70), umfassend:
ein Substrat (300);
eine dritte supraleitende Metallschicht (340), die auf dem Substrat gebildet ist;
eine Josephson-Vorrichtung (3), welche eine erste supraleitende Metallschicht (310) beinhaltet, die eine erste Fläche (311) beinhaltet,
eine zweite supraleitende Metallschicht (320), die eine zweite Fläche (322) beinhaltet, welche der ersten Fläche zugewandt ist, und eine isolierende Schicht (330), die zwischen der ersten Fläche und der zweiten Fläche vorgesehen ist, und auf der dritten supraleitenden Metallschicht gebildet ist, und in welcher die erste supraleitende Metallschicht in Kontakt mit der dritten supraleitenden Metallschicht ist; und
eine vierte supraleitende Metallschicht (450), die mit der zweiten supraleitenden Metallschicht gekoppelt ist,
wobei eine Umrisslinie der zweiten Fläche innerhalb einer Umrisslinie der ersten Fläche in einer Draufsicht aus einer Richtung senkrecht zu der ersten Fläche liegt, und
wobei eine Vertiefung (701) auf einer Fläche des Substrats unterhalb der Josephson-Vorrichtung gebildet ist, und ein Zwischenraum zwischen der dritten supraleitenden Metallschicht und dem Substrat existiert.

2. Supraleitende Schaltung nach Anspruch 1, wobei eine Peripherie der Josephson-Vorrichtung hohl ist.

3. Supraleitende Schaltung nach Anspruch 1, ferner umfassend eine dielektrische Schicht (390), die eine Peripherie der Josephson-Vorrichtung umgibt.

4. Supraleitende Schaltung nach einem der vorhergehenden Ansprüche, ferner umfassend
eine fünfte supraleitende Metallschicht (460), die auf dem Substrat (300) gebildet ist,
wobei die vierte supraleitende Metallschicht (450) in Kontakt mit der zweiten supraleitenden Metallschicht (320) und der fünften supraleitenden Metallschicht ist.

5. Supraleitende Schaltung nach Anspruch 4, wobei die fünfte supraleitende Metallschicht (460) Al, Nb, Nb-Nitrid, Ta, Ta-Nitrid oder Ti-Nitrid beinhaltet.

6. Supraleitende Schaltung nach einem der vorhergehenden Ansprüche, wobei ein Graben (601) in einer Region um die Josephson-Vorrichtung in einer Draufsicht einer Fläche des Substrats (300) gebildet ist.

7. Supraleitende Schaltung nach einem der vorhergehenden Ansprüche, wobei die dritte supraleitende Metallschicht (340) und die vierte supraleitende Metallschicht (450) Al, Nb, Nb-Nitrid, Ta, Ta-Nitrid oder Ti-Nitrid beinhalten.

8. Supraleitende Schaltung nach einem der vorhergehenden Ansprüche, wobei
die erste Fläche und die zweite Fläche eine kreisförmige Gestalt haben, und
ein Durchmesser der zweiten Fläche kleiner ist als ein Durchmesser der ersten Fläche.

9. Supraleitende Schaltung nach einem der vorhergehenden Ansprüche, wobei die erste supraleitende Metallschicht (310) und die zweite supraleitende Metallschicht (320) Al, Nb, Nb-Nitrid, Ta, Ta-Nitrid oder Ti-Nitrid beinhalten.

10. Quantenberechnungsvorrichtung (800), umfassend die supraleitende Schaltung nach einem der vorhergehenden Ansprüche.

11. Verfahren zum Herstellen einer Josephson-Vorrichtung (1, 2), umfassend:
Bilden einer Maske (191, 192, 291, 292), die eine Öffnung auf einem Substrat (100) beinhaltet;
Bilden einer ersten supraleitenden Metallschicht (110, 210), die eine erste Fläche (111, 211) hat, auf dem Substrat durch die Öffnung durch Zuführen einer ersten Verdampfungssubstanz in Richtung einer oberen Oberfläche des Substrats;
Bilden einer isolierenden Schicht (130, 230) durch Oxidieren der ersten Fläche der ersten supraleitenden Metallschicht; und
Bilden einer zweiten supraleitenden Metallschicht (120, 220), die eine zweite Fläche (122, 222) hat, welche der ersten Fläche zugewandt ist, auf der isolierenden Schicht durch die Öffnung durch Zuführen einer zweiten Verdampfungssubstanz in Richtung der oberen Fläche,
wobei beim Bilden der zweiten supraleitenden Metallschicht die zweite Verdampfungssubstanz derart zugeführt wird, dass eine Umrisslinie der zweiten Fläche innerhalb einer Umrisslinie der ersten Fläche in einer Draufsicht aus einer Richtung senkrecht zu der ersten Fläche positioniert ist.

12. Verfahren zum Herstellen einer Josephson-Vorrichtung nach Anspruch 11, wobei
das Bilden der ersten supraleitenden Metallschicht (210) beinhaltet:
Rotieren des Substrats (100) um eine gerade Linie, die durch ein Zentrum der oberen Fläche verläuft und senkrecht zu der oberen Fläche ist, als ein Rotationszentrum; und
Zuführen der ersten Verdampfungssubstanz aus einer Richtung, die von der geraden Linie in Richtung der oberen Fläche geneigt ist.

13. Verfahren zum Herstellen einer Josephson-Vorrichtung nach Anspruch 11 oder 12, wobei das Bilden der ersten supraleitenden Metallschicht (110, 210), das Bilden der isolierenden Schicht (130, 230) und das Bilden der zweiten supraleitenden Metallschicht (120, 220) durchgeführt werden, während ein Vakuumzustand in einer Vakuumkammer aufrechterhalten wird.

## Revendications

1. Circuit supraconducteur (70) comprenant :
un substrat (300) ;
une troisième couche métallique supraconductrice (340) formée sur le substrat ;
un dispositif Josephson (3), qui comprend une première couche métallique supraconductrice (310) qui comprend une première surface (311),
une deuxième couche métallique supraconductrice (320) qui comprend une seconde surface (322) qui fait face à la première surface, et une couche isolante (330) disposée entre la première surface et la seconde surface, et est formée sur la troisième couche métallique supraconductrice, et dans laquelle la première couche métallique supraconductrice est en contact avec la troisième couche métallique supraconductrice ; et
une quatrième couche métallique supraconductrice (450) couplée à la deuxième couche métallique supraconductrice,
dans lequel un contour de la seconde surface se trouve à l'intérieur d'un contour de la première surface dans une vue en plan à partir d'une direction perpendiculaire à la première surface, et
dans lequel un évidement (701) est formé sur une surface du substrat au-dessous du dispositif Josephson, et un espace existe entre la troisième couche métallique supraconductrice et le substrat.

2. Circuit supraconducteur selon la revendication 1, dans lequel une périphérie du dispositif Josephson est creuse.

3. Circuit supraconducteur selon la revendication 1, comprenant en outre une couche diélectrique (390) qui entoure une périphérie du dispositif Josephson.

4. Circuit supraconducteur selon une quelconque revendication précédente, comprenant en outre
une cinquième couche métallique supraconductrice (460) formée sur le substrat (300),
dans lequel la quatrième couche métallique supraconductrice (450) est en contact avec la deuxième couche métallique supraconductrice (320) et la cinquième couche métallique supraconductrice.

5. Circuit supraconducteur selon la revendication 4, dans lequel la cinquième couche métallique supraconductrice (460) comprend de l'Al, du Nb, du nitrure de Nb, du Ta, du nitrure de Ta ou du nitrure de Ti.

6. Circuit supraconducteur selon une quelconque revendication précédente, dans lequel une tranchée (601) est formée dans une région autour du dispositif Josephson dans une vue en plan d'une surface du substrat (300).

7. Circuit supraconducteur selon une quelconque revendication précédente, dans lequel la troisième couche métallique supraconductrice (340) et la quatrième couche métallique supraconductrice (450) comprennent de l'Al, du Nb, du nitrure de Nb, du Ta, du nitrure de Ta ou du nitrure de Ti.

8. Circuit supraconducteur selon une quelconque revendication précédente, dans lequel
la première surface et la seconde surface ont une forme circulaire, et
un diamètre de la seconde surface est inférieur à un diamètre de la première surface.

9. Circuit supraconducteur selon une quelconque revendication précédente, dans lequel la première couche métallique supraconductrice (310) et la deuxième couche métallique supraconductrice (320) comprennent de l'Al, du Nb, du nitrure de Nb, du Ta, du nitrure de Ta ou du nitrure de Ti.

10. Dispositif à opérations quantiques (800) comprenant le circuit supraconducteur selon une quelconque revendication précédente.

11. Procédé de fabrication d'un dispositif Josephson (1, 2), comprenant :
la formation d'un masque (191, 192, 291, 292) qui comprend une ouverture sur un substrat (100) ;
la formation d'une première couche métallique supraconductrice (110, 210) qui a une première surface (111, 211) sur le substrat à travers l'ouverture en fournissant une première substance d'évaporation vers une surface supérieure du substrat ;
la formation d'une couche isolante (130, 230) en oxydant la première surface de la première couche métallique supraconductrice ; et
la formation d'une deuxième couche métallique supraconductrice (120, 220) qui a une seconde surface (122, 222) qui fait face à la première surface sur la couche isolante à travers l'ouverture en fournissant une seconde substance d'évaporation vers la surface supérieure,
dans lequel, lors de la formation de la deuxième couche métallique supraconductrice, la seconde substance d'évaporation est fournie de telle sorte qu'un contour de la seconde surface est positionné à l'intérieur d'un contour de la première surface dans une vue en plan à partir d'une direction perpendiculaire à la première surface.

12. Procédé de fabrication d'un dispositif Josephson selon la revendication 11, dans lequel
la formation de la première couche métallique supraconductrice (210) comprend :
la rotation du substrat (100) autour d'une ligne droite qui passe par un centre de la surface supérieure et est perpendiculaire à la surface supérieure comme centre de rotation ; et
la fourniture de la première substance d'évaporation à partir d'une direction inclinée par rapport à la ligne droite vers la surface supérieure.

13. Procédé de fabrication d'un dispositif Josephson selon la revendication 11 ou 12, dans lequel la formation de la première couche métallique supraconductrice (110, 210), la formation de la couche isolante (130, 230) et la formation de la deuxième couche métallique supraconductrice (120, 220) sont effectuées pendant qu'un état de vide est maintenu dans une chambre à vide.
